(19) Europäisches Patentamt
European Patent Office
Office européen des brevets

(11) **EP 4 468 842 A1**

(12) **EUROPEAN PATENT APPLICATION**

(43) Date of publication:
**27.11.2024   Bulletin 2024/48**

(21) Application number: **24153973.3**

(22) Date of filing: **25.01.2024**

(51) International Patent Classification (IPC):
**H10B 41/27** (2023.01)       **H01L 21/768** (2006.01)
**H10B 41/50** (2023.01)       **H10B 43/27** (2023.01)
**H10B 43/50** (2023.01)

(52) Cooperative Patent Classification (CPC):
**H10B 43/27; H01L 21/76805; H10B 41/27; H10B 41/50; H10B 43/50**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH MA MD TN**

(30) Priority: **26.05.2023   KR 20230068426**

(71) Applicant: **Samsung Electronics Co., Ltd.
Suwon-si, Gyeonggi-do 16677 (KR)**

(72) Inventors:
• KWON, Joonyoung
  Suwon-si (KR)
• KIM, Junhyoung
  Suwon-si (KR)
• KIM, Jiyoung
  Suwon-si (KR)
• SUNG, Sukkang
  Suwon-si (KR)

(74) Representative: **Marks & Clerk LLP
15 Fetter Lane
London EC4A 1BW (GB)**

(54) **SEMICONDUCTOR DEVICE AND METHOD FOR MANUFACTURING THE SAME, AND ELECTRONIC SYSTEM INCLUDING SEMICONDUCTOR DEVICE**

(57)    A semiconductor device including a substrate having a cell array region and a contact region, a gate stack structure positioned in the cell array region, and including a plurality of interlayer insulation layers and a plurality of gate electrodes alternately stacked on the substrate, a gate pattern stack structure positioned in the contact region, and including a plurality of gate patterns extending from the plurality of gate electrodes, and a plurality of insulation layers alternately stacked with the plurality of gate patterns, a channel structure penetrating the gate stack structure and extending in a direction crossing or intersecting the substrate, and a gate contact portion in the contact region, and penetrating at least a portion of the gate pattern stack structure to be electrically connected to the gate pattern, the plurality of insulation layers including a first insulation layer and a second insulation layer, the second insulating layer including a material different from a material included in the first insulation layer.

FIG. 1

**Description**

BACKGROUND

1. Field

Embodiments relate to a semiconductor device, a method for manufacturing the semiconductor device, and an electronic system including a semiconductor device.

2. Description of the Related Art

A semiconductor is a material belonging to an intermediate area between a conductor and an insulator, and refers to a material that conducts electricity under certain conditions. Various semiconductor devices may be manufactured using the semiconductor materials, and memory devices and the like may be manufactured. Memory devices may be classified into volatile memory devices and non-volatile memory devices. In the case of non-volatile memory devices, contents may not be deleted even if power is cut off, and may be used in various electronic devices such as mobile phones, digital cameras, and PCs.

In accordance with the recent trend of increasing storage capacity, the degree of integration of non-volatile memory devices is required to be improved. The degree of integration of memory devices two-dimensionally arranged on a plane may be limited. Accordingly, a vertical non-volatile memory device arranged in three dimensions has been proposed.

SUMMARY

The present disclosure is directed to a semiconductor device, a method for manufacturing the same, and a data storage system including a semiconductor device, capable of improving reliability and productivity.

Embodiments are directed to a semiconductor device, including a substrate having a cell array region and a contact region, the cell array region including a gate stack structure having a plurality of interlayer insulation layers and a plurality of gate electrodes alternately stacked on the substrate, the contact region including a gate pattern stack structure having a plurality of gate patterns and a plurality of insulation layers alternately stacked on the substrate, the plurality of gate patterns extending from and integral with the plurality of gate electrodes, the plurality of insulation layers including a first insulation layer and a second insulation layer, the second insulation layer being made of a material different than the first insulation layer, the contact region further including a gate contact portion penetrating at least a portion of the gate pattern stack structure and electrically connected to the gate pattern, and a channel structure penetrating the gate stack structure and extending in a direction intersecting the substrate.

Embodiments are directed to an electronic system, including a main substrate, a semiconductor device on the main substrate, and a controller electrically connected to the semiconductor device on the main substrate, the semiconductor device having a circuit region including a peripheral circuit structure and a cell region on the circuit region and including a cell array region and a contact region, the cell region having a gate stack structure in the cell array region, including a plurality of interlayer insulation layers and a plurality of gate electrodes alternately stacked on the substrate, a gate pattern stack structure in the contact region, including a plurality of gate patterns and a plurality of insulation layers alternately stacked, the plurality of gate patterns extending from and integral with the plurality of gate electrodes, the plurality of insulation layers including at least one first insulation layer and at least one second insulation layer, the second insulation layer being made of a material different than the first insulation layer, the contact region further including a gate contact portion penetrating at least a portion of the gate pattern stack structure and electrically connected to the gate pattern, and a channel structure penetrating the gate stack structure to extend in a direction intersecting the substrate.

Embodiments are directed to a method for manufacturing a semiconductor device, the method including forming a stack structure by forming a sacrificial insulation layer, a second insulation layer, and a first insulation layer comprising a material different from the second insulation layer that are stacked consecutively and repeatedly on a circuit region having a peripheral circuit structure, forming holes having different depths to expose the second insulation layer by etching at least a portion of the stack structure, and forming contact holes to expose the sacrificial insulation layer by etching a portion of the second insulation layer exposed through the hole, forming a gate spacer within the contact holes, removing the sacrificial insulation layer, and forming a gate pattern in the region where the sacrificial insulation layer is removed, and etching a lower surface of the gate spacer, and forming a gate contact portion filling the contact holes.

According to an embodiment, a semiconductor device is provided with a plurality of gate patterns and a plurality of insulation layers alternately stacked on a substrate. One or more of (e.g. each of) the plurality of insulation layers may include a corresponding first insulation layer and a corresponding second insulation layer made of a different material to that of the first insulation layer. One or more channel structures may penetrate the gate stack structure, extending in a direction intersecting the substrate. One or more gate contacts may penetrate at least a portion of the gate pattern stack structure. Each gate contact may be connected to a corresponding one of the gate patterns.

One or more (e.g. each) of the gate patterns may be formed as a same layer as a corresponding gate electrode. That is, one or more (e.g. each) of the gate patterns may be connected to, or integrally formed with, a corresponding gate electrode. The one or more (e.g. each) of the gate patterns may be formed in the same layer as the corresponding gate electrode. The one or more (e.g. each) of the gate patterns may extend from the corresponding gate electrode.

One or more (e.g. each) of the interlayer insulation layers may include a first interlayer insulation layer and a second interlayer insulation layer positioned on a corresponding gate electrode. One or more (e.g. each) of the second insulation layers may be formed as a same layer as a corresponding the second interlayer insulation layer. One or more (e.g. each) of the first insulation layers may be formed as a same layer as a corresponding first interlayer insulation layer.

According to example embodiments, since a gate pattern stack structure of a semiconductor device may include a second insulation layer, an etching process for forming a contact hole may be easily controlled. In addition, since the second insulation layer has a low permittivity, parasitic capacitance between gate patterns may be reduced. Accordingly, reliability and productivity of the semiconductor device may be improved.

At least some of the above and other features of the invention are set out in the claims.

BRIEF DESCRIPTION OF THE DRAWINGS

Features will become apparent to those of skill in the art by describing in detail example embodiments with reference to the attached drawings, in which:

FIG. 1 is a cross-sectional view showing a semiconductor device according to an embodiment;
FIG. 2A and FIG. 2B are cross-sectional views showing various examples of a channel structure included in the semiconductor device shown in FIG. 1;
FIG. 3 is an enlarged cross-sectional view of a region P1 of FIG. 1;
FIG. 4 is a graph showing the intensity of light for a detection element over time in an etching process;
FIGS. 5 to 16 are process cross-sectional views sequentially illustrating a method of manufacturing a semiconductor device according to an embodiment;
FIGS. 17 to FIG. 21 are enlarged cross-sectional views corresponding to P1 of FIG. 1 illustrating semiconductor devices according to various embodiments;
FIG. 22 is a cross-sectional view illustrating a semiconductor device according to an embodiment;
FIG. 23 is a cross-sectional view illustrating an example of a channel structure included in the semiconductor device shown in FIG. 22;
FIG. 24 is a cross-sectional view illustrating a semiconductor device according to an embodiment;
FIG. 25 is a cross-sectional view illustrating a semiconductor device according to an embodiment;
FIG. 26 is a drawing schematically illustrating an electronic system including a semiconductor device according to an embodiment;
FIG. 27 is a perspective view schematically illustrating an electronic system including a semiconductor device according to an embodiment; and
FIGS. 28 and FIG. 29 are cross-sectional views schematically illustrating a semiconductor package according to an embodiment.

DETAILED DESCRIPTION

The present disclosure will be described more fully hereinafter with reference to the accompanying drawings, in which embodiments of the disclosure are shown. As those skilled in the art would realize, the described embodiments may be modified in various different ways, all without departing from the spirit or scope of the present disclosure.

In order to clearly describe the present invention, parts or portions that are irrelevant to the description are omitted, and identical or similar constituent elements throughout the specification are denoted by the same reference numerals.

Further, in the drawings, the size and thickness of each element are arbitrarily illustrated for ease of description, and the present disclosure is not necessarily limited to those illustrated in the drawings. In the drawings, the thicknesses of layers, films, panels, regions, areas, etc., are exaggerated for clarity. In the drawings, for ease of description, the thicknesses of some layers and areas are exaggerated.

It will be understood that when an element such as a layer, film, region, or substrate is referred to as being "on" another element, it can be directly on the other element or intervening elements may also be present. In contrast, when an element is referred to as being "directly on" another element, there are no intervening elements present. Further, in the specification, the word "on" or "above" means disposed on or below the object portion, and does not necessarily mean disposed on the upper side of the object portion based on a gravitational direction.

In addition, unless explicitly described to the contrary, the word "comprise" and variations such as "comprises" or "comprising" will be understood to imply the inclusion of stated elements but not the exclusion of any other elements.

Further, throughout the specification, the phrase "in a plan view" or "on a plane" means viewing a target portion from the top (e.g. along a direction crossing, or perpendicular, to the substrate), and the phrase "in a cross-sectional view" or "on a cross-section" means viewing a cross-section formed by vertically cutting a target portion from the side (e.g. along a direction crossing, or perpendicular, to the substrate).

Where a single instance of a plurality of components is described, it will be appreciated that other instances of the plurality of components may have the same features.

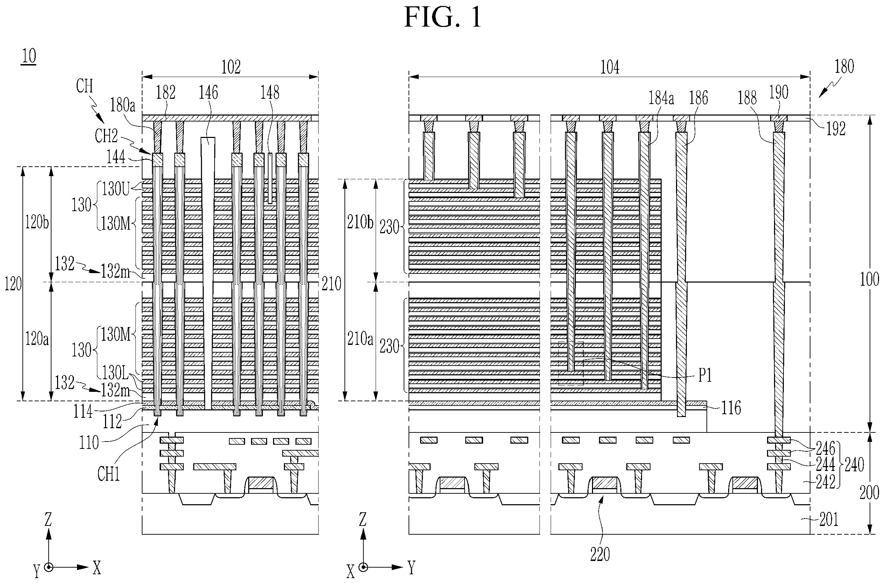

Hereinafter, a semiconductor device according to an embodiment will be described with reference to FIG. 1, FIG. 2A, FIG. 2B, and FIG. 3.

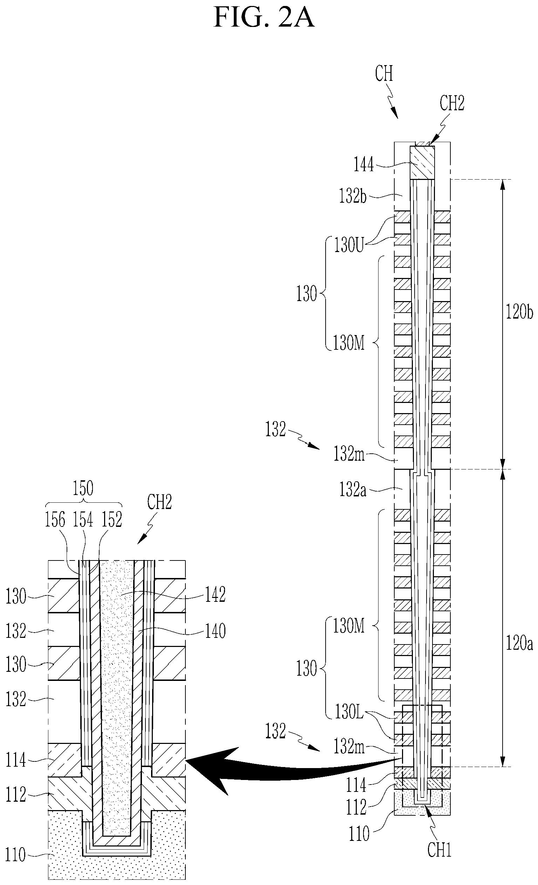

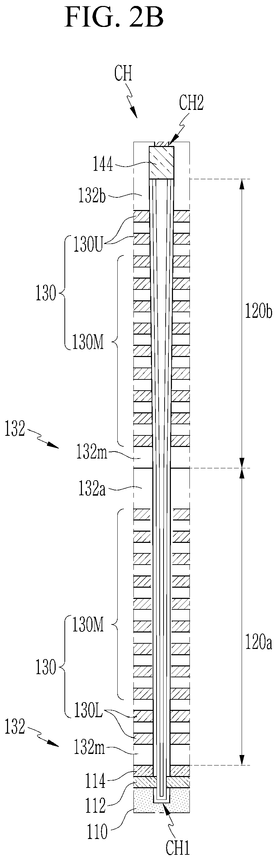

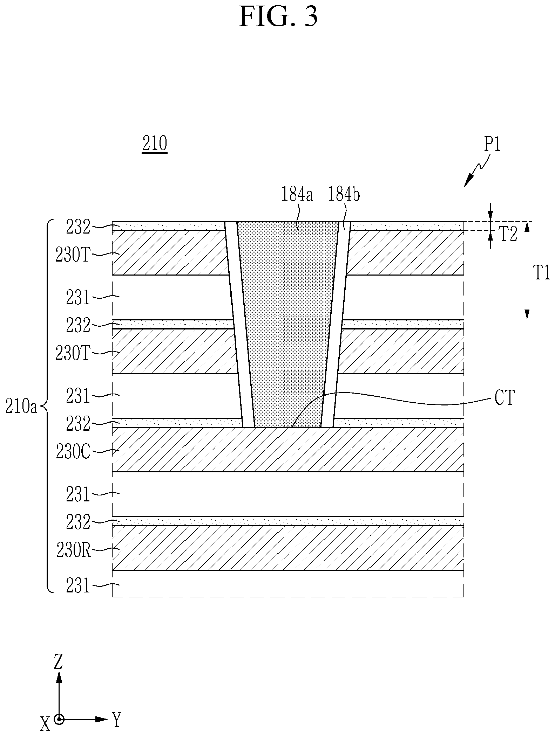

FIG. 1 is a cross-sectional view showing a semiconductor device according to an embodiment. FIG. 2A and FIG. 2B are cross-sectional views showing various examples of a channel structure included in the semiconductor device shown in FIG. 1. FIG. 3 is an enlarged cross-sectional view of a region P1 of FIG. 1.

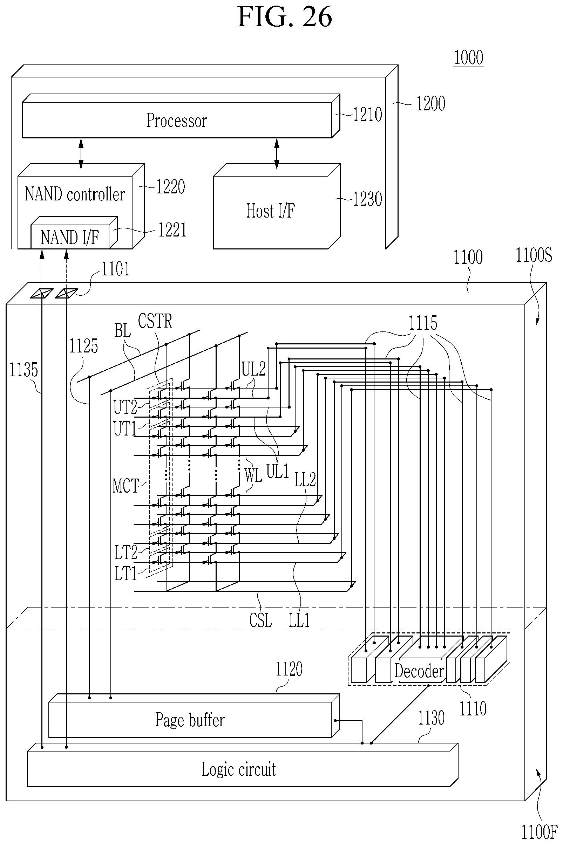

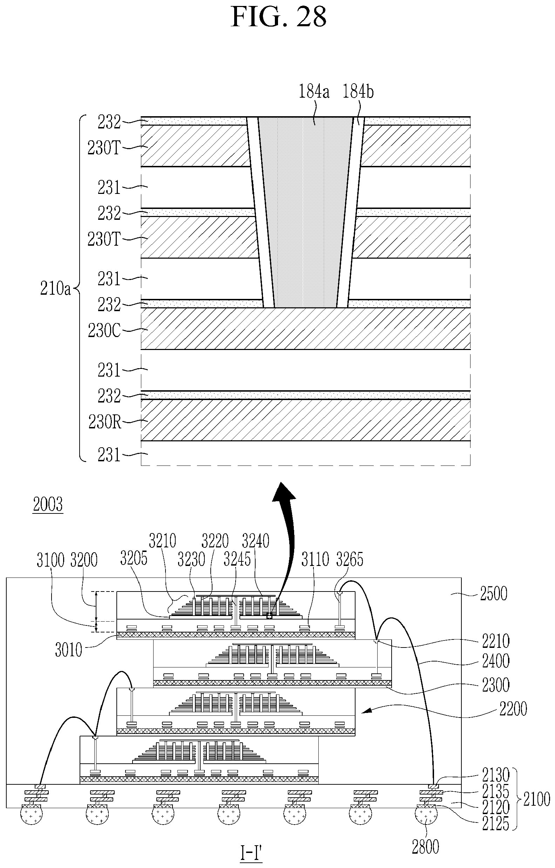

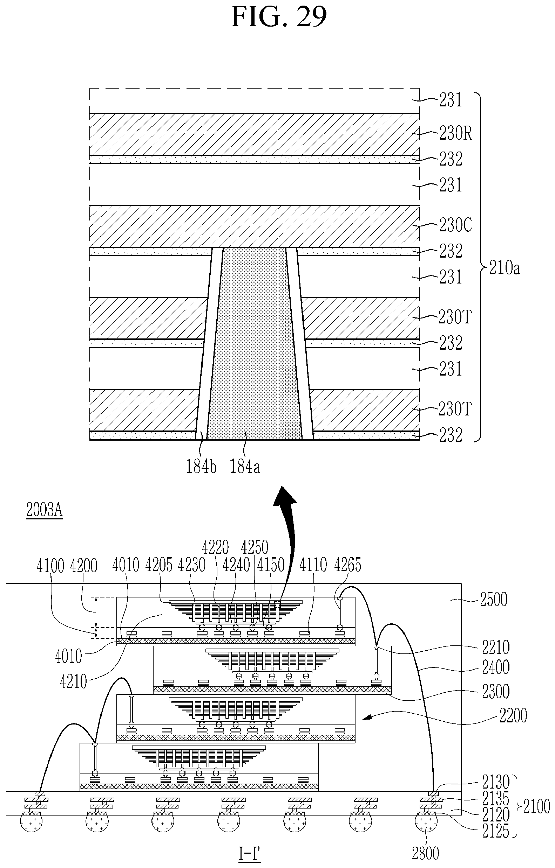

Referring to FIG. 1 and FIG. 2A, a semiconductor device 10 according to an embodiment may include a cell region 100 having a memory cell structure and a circuit region 200 having a peripheral circuit structure configured to control the operation of the memory cell structure. In an implementation, the circuit region 200 and the cell region 100 may correspond to a first structure 1100F and a second structure 11005 of a semiconductor device 1100 included in an electronic system 1000 shown in FIG. 26, respectively. Alternatively, the circuit region 200 and the cell region 100 may correspond to first structures 3100 and 4100 and second structures 3200 and 4200 of a semiconductor chip 2200 shown in FIG. 28 or FIG. 29, respectively.

Here, the circuit region 200 may include the peripheral circuit structure positioned on a first substrate 201, and the cell region 100 may include a gate stack structure 120 and one or more channel structures CH positioned on a cell array region 102 of a second substrate 110 as memory cell structures. In an embodiment, the circuit region 200 included a plurality of channel structures CH. For simplicity, the arrangement of a single channel structure CH will be described; however, unless explicitly stated otherwise, it will be appreciated that other channel structures may have the same arrangement, and so the description of the channel structure CH will equally apply to the other channel structures. A first wire portion 240 electrically connected to the peripheral circuit structure may be positioned in the circuit region 200, and a second wire portion 180 electrically connected to the memory cell structure may be positioned in the cell region 100.

In an embodiment, the cell region 100 may be located on the circuit region 200. According to this embodiment, since an area corresponding to the circuit region 200 does not need to be secured separately from the cell region 100, the area of the semiconductor device 10 may be reduced. Embodiments, however, are not so limited, e.g., the circuit region 200 may be located adjacent to the cell region 100, and various other modifications are available.

The circuit region 200 may include the first substrate 201, and circuit elements 220 and the first wire portion 240 positioned on the first substrate 201.

The first substrate 201 may be a semiconductor substrate including a semiconductor material. In an implementation, the first substrate 201 may be a semiconductor substrate made of a semiconductor material, or may be a semiconductor substrate on which a semiconductor layer is formed on a base substrate. In an implementation, the first substrate 201 may be made of silicon, epitaxial silicon, germanium, silicon-germanium, silicon-on-insulator (SOI), or germanium-on-insulator (GOI), and the like.

The circuit element 220 formed on the first substrate 201 may include various circuit elements that control the operation of the memory cell structure provided in the cell region 100. In an implementation, the circuit element 220 may configure the peripheral circuit structures such as a decoder circuit (reference numeral 1110 in FIG. 26), a page buffer (reference numeral 1120 in FIG. 26), a logic circuit (reference numeral 1130 in FIG. 26), and the like.

The circuit element 220 may include, e.g., a transistor, but is not limited thereto. In an implementation, the circuit element 220 may include not only active elements such as transistors, but also passive elements such as capacitors, resistors, and inductors.

The first wire portion 240 positioned on the first substrate 201 may be electrically connected to the circuit element 220. In an embodiment, the first wire portion 240 includes a plurality of wire layers 246 spaced apart interposing the first wire insulation layer 242 therebetween and connected by contact vias 244 to form a desired path. The wire layer 246 or the contact via 244 may include various conductive materials, and the first wire insulation layer 242 may include various insulating materials.

The cell region 100 may include the cell array region 102 and a contact region 104. The gate stack structure 120 and the channel structure CH may be positioned on the second substrate 110 in the cell array region 102. A gate pattern stack structure 210, a gate contact portion 184a for connecting the gate stack structure 120 of the cell array region 102 to the circuit region 200 or external circuit, and/or a structure for connecting the channel structure CH to the circuit region 200 or external circuit may be positioned on the second substrate 110 in the contact region 104.

In an embodiment, the second substrate 110 may include a semiconductor material. In an implementation, the second substrate 110 may include polysilicon doped with impurities. The second substrate 110 may function as a common source line. The second substrate 110 may function as a source region supplying current to memory cells positioned on the second substrate 110. The second substrate 110 may have a plate shape. That is, the second substrate 110 may have a plate shaped common source line.

At least a portion of the first wire insulation layer 242 may be positioned between the second substrate 110 and the first wire portion 240. A portion of the first wire insulation layer 242 positioned between the second substrate 110 and the first wire portion 240 may have a single layer or multiple layers. In an implementation, a layer containing silicon nitride and a layer containing silicon oxide may be positioned between the second substrate 110 and the first wire portion 240. In this case, a layer containing silicon oxide may be positioned on a layer containing silicon nitride.

The gate stack structure 120 including cell insulation layers 132 and gate electrodes 130 alternately stacked on a first surface, e.g., a front surface or an upper surface, of the second substrate 110, and the channel structures CH penetrating the gate stack structure 120 and extending in a direction crossing or intersecting the second substrate 110 may be in the cell array region 102. The gate electrodes 130, cell insulation layers 132 and channel structures CH are described below. For simplicity, the arrangement of a single gate electrode 130, a single cell insulation layer 132 and a single channel structure CH will be described; however, unless explicitly stated otherwise, it will be appreciated that other gate electrodes, other cell insulation layers and other channel structures may have the same arrangement, and so the description will equally apply to these other components.

Horizontal conductive layers 112 and 114 may be provided between the second substrate 110 and the gate stack structure 120 in the cell array region 102. The horizontal conductive layers 112 and 114 may serve to electrically connect between the channel structure CH and the second substrate 110. In an implementation, the horizontal conductive layers 112 and 114 may include a first horizontal conductive layer 112 on a first surface (e.g. an upper surface) of the second substrate 110, and may further include a second horizontal conductive layer 114 on the first horizontal conductive layer 112. That is, the first horizontal conductive layer 112 may be between the second substrate 110 and the second horizontal conductive layer 114. The first horizontal conductive layer 112 may not be provided, but a horizontal insulation layer 116 may be provided, between the second substrate 110 and the gate stack structure 120 in a partial region of the contact region 104. In the manufacturing process, a part of the horizontal insulation layer 116 may be replaced with the first horizontal conductive layer 112, and another part of the horizontal insulation layer 116 located in the contact region 104 may remain in the contact region 104. As discussed herein, the term "horizontal" may refer to any direction that is parallel to an upper surface of at least one of the first substrate 201 and the second substrate 110. Similarly, the term "vertical" may refer to a direction that is perpendicular to an upper surface of at least one of the first substrate 201 and the second substrate 110. It will be appreciated that these terms are relative to the structure of the semiconductor device 10, and need not imply any particular orientation of the semiconductor device 10 in use.

The first horizontal conductive layer 112 may function as a part of a common source line of the semiconductor device 10. In an implementation, the first horizontal conductive layer 112 together with the second substrate 110 may function as a common source line. As shown in the enlarged view of FIG. 2A, the channel structure CH penetrates the horizontal conductive layers 112 and 114 and extends to reach the second substrate 110, and a gate dielectric layer 150 is removed at a portion where the first horizontal conductive layer 112 is located, such that the first horizontal conductive layer 112 may be directly connected to the channel layer 140 at a side wall (e.g. at a circumference) of the channel layer 140. Therefore, the first horizontal conductive layer 112 may electrically connect between the second substrate 110 and the channel layer 140.

The first and second horizontal conductive layers 112 and 114 may include a semiconductor material, e.g., polysilicon. In an implementation, the first horizontal conductive layer 112 may include polysilicon doped with impurities, and the second horizontal conductive layer 114 may include polysilicon doped with impurities or may be a layer containing impurities diffused from the first horizontal conductive layer 112. However, the embodiments are not limited thereto, and the second horizontal conductive layer 114 may include an insulating material. Alternatively, the second horizontal conductive layer 114 may not be provided separately.

The gate stack structure 120 in which the cell insulation layers 132 and the gate electrodes 130 are alternately stacked may be on the second substrate 110, e.g., on the first and second horizontal conductive layers 112 and 114 on the second substrate 110.

In an embodiment, the gate stack structure 120 may include a plurality of gate stack structures 120a and 120b sequentially stacked on the second substrate 110. Then, since the number of the stacked gate electrode 130 may be increased, the number of memory cells may be increased with a stable structure. In an implementation, the gate stack structure 120 may include the first and second gate stack structures 120a and 120b to increase data storage capacity while simplifying the structure. However, the embodiments are not limited thereto, and the gate stack structure 120 may include one gate stack structure or three or more gate stack structures.

In the gate stack structure 120, the gate electrodes 130 may include a lower gate electrode 130L, a memory cell gate electrode 130M, and an upper gate electrode 130U sequentially positioned on the second substrate 110. The lower gate electrode 130L may be used as a gate electrode of a ground select transistor, the memory cell gate electrode 130M may constitute a memory cell, and the upper gate electrode 130U may be used as a gate electrode of a string select transistor. The number of memory cell gate electrodes 130M may be determined according to the data storage capacity of the semiconductor device 10. Depending on the embodiment, each of the lower gate electrode 130L and the upper gate electrode 130U may be provided in a quantity of one or two or more, and may have a structure that is the same as or different from the memory cell gate electrode 130M. In an implementation, a portion of the gate electrodes 130, the memory cell gate electrode 130M adjacent to the lower gate electrode 130L and the upper gate electrode 130U may be a dummy gate electrode.

The cell insulation layer 132 may include an interlayer insulation layer 132m positioned below the gate electrodes 130 or between adjacent two gate electrodes 130 within the first and second gate stack structures 120a and 120b, and upper insulation layers 132a and 132b positioned in an upper portion of the first and second gate stack structures 120a and 120b. In an implementation, the upper insulation layers 132a and 132b may include a first upper insulation layer 132a positioned in an upper portion of a first gate stack structure 120a, and a second upper insulation layer 132b positioned in an upper portion of a second gate stack structure 120b. At this time, the first upper insulation layer 132a is an intermediate insulation layer positioned between the first gate stack structure 120a and the second gate stack structure 120b, and the second upper insulation layer 132b is an uppermost insulation layer positioned in an uppermost portion of the gate stack structure 120. The second upper insulation layer 132b may constitute part or all of the cell region insulation layer positioned entirely over the cell region 100. In an embodiment, the thicknesses of the plurality of cell insulation layers 132 may not all be the same. In an implementation, thicknesses of the upper insulation layers 132a and 132b may be greater than a thickness of the interlayer insulation layer 132m. However, a shape, a structure, and the like of the cell insulation layer 132 may be variously changed according to embodiments.

For simplicity of illustration, an example is illustrated in which the cell insulation layer 132 in the contact region 104 has a boundary between the first stack structure 120a and the second stack structure 120b. However, embodiments are not limited thereto. A plurality of insulation layers in the contact region 104 may have various stack structures, and the embodiments are not limited thereto.

The gate electrodes 130 may include various conductive materials. In an implementation, the gate electrodes 130 may include a metal material such as tungsten (W), copper (Cu), aluminum (Al), and the like. As another example, the gate electrodes 130 may include polysilicon, metal nitride, e.g., titanium nitride (TiN), tantalum nitride (TaN), and the like, or a combination thereof. Although not shown in the drawing figures, on an outer side of the gate electrodes 130, an insulating film made of an insulating material may be provided or a portion of the gate dielectric layer 150 may be provided. The cell insulation layers 132 may include various insulating materials, e.g., a low permittivity material having a lower dielectric constant than silicon oxide, silicon nitride, silicon nitride oxide, silicon oxide, or a combination thereof.

In an embodiment, the channel structure CH may penetrate the gate stack structure 120 and extend in a direction crossing or intersecting the second substrate 110, i.e., a vertical direction perpendicular to the second substrate 110 (Z-axis direction in the drawing).

In further detail, the channel structure CH may include the channel layer 140, and the gate dielectric layer 150 positioned on the channel layer 140 between the gate electrode 130 and the channel layer 140. The channel structure CH may further include a core insulation layer 142 positioned in an interior of the channel layer 140, and may further include a channel pad 144 disposed on the channel layer 140 and/or the gate dielectric layer 150.

Each of the channel structures CH forms one memory cell string, and a plurality of channel structures CH may be spaced apart from each other while forming rows and columns on a plane. In an implementation, the plurality of channel structures CH may be arranged in various shapes such as a lattice shape or a zigzag shape on a plane. The channel structure CH may have a column shape. In an implementation, in a cross-sectional view, the channel structure CH may have an inclined side surface having a width that narrows as it approaches the second substrate 110 according to the aspect ratio. However, the embodiments are not limited thereto, and the arrangement, structure, and shape of the channel structure CH may be variously changed.

The core insulation layer 142 may be provided in a central region of the channel structure CH, and the channel layer 140 may surround sidewalls of the core insulation layer 142. In an implementation, the core insulation layer 142 may have a column shape, i.e., a cylindrical shape or a polygonal column shape, and the channel layer 140 may have a planar shape such as an annular shape. However, embodiments are not limited thereto, and while the core insulation layer 142 is not provided, the channel layer 140 may have a column shape, e.g., a cylindrical shape or a polygonal column shape.

The channel layer 140 may include a semiconductor material, e.g., polysilicon. The core insulation layer 142 may include various insulating materials. In an implementation, the core insulation layer 142 may include silicon oxide, silicon nitride, silicon nitride oxide, or combination thereof. However, materials of the channel layer 140 and the core insulation layer 142 are not limited thereto.

The gate dielectric layer 150 between the gate electrode 130 and the channel layer 140 may include a tunneling layer 152, a charge storage layer 154 and a blocking layer 156 that are sequentially stacked on the channel layer 140. In this case, the tunneling layer 152 is a layer through which charges are tunneled according to the voltage applied to the gate electrode 130 and may include an insulating material capable of tunneling charges. The tunneling layer 152 may include a material such as silicon oxide or silicon nitride. In an implementation, the tunneling layer 152 may be formed by stacking a layer containing silicon oxide and a layer containing silicon nitride.

The charge storage layer 154 disposed between the tunneling layer 152 and the blocking layer 156 may be used as a data storage region. In an implementation, the charge storage layer 154 may include silicon nitride capable of trapping charges. When the charge storage layer 154 is made of silicon nitride, retention is superior to that made of polysilicon, and it may be advantageous for integration. However, the material of the charge storage layer 154 is not limited thereto.

The blocking layer 156 may be between the charge storage layer 154 and the gate electrodes 130. The blocking layer 156 may include an insulating material capable of preventing an undesirable flow of charges into the gate electrodes 130. In an implementation, the blocking layer 156 may include silicon oxide, silicon nitride, silicon nitride oxide, high permittivity material, or a combination thereof.

High permittivity material means a dielectric material having a higher dielectric constant than silicon oxide. In an implementation, the high permittivity material may include aluminum oxide ($Al_2O_3$), tantalum oxide ($Ta_2O_3$), titanium oxide $TiO_2$, yttrium oxide $Y_2O_3$, zirconium oxide $ZrO_2$, zirconium silicon oxide ($ZrSi_xO_y$), hafnium oxide $HfO_2$, hafnium silicon oxide ($HfSi_xO_y$), lanthanum oxide ($La_2O_3$), lanthanum aluminum oxide ($LaAl_xO_y$), lanthanum hafnium oxide ($LaHf_xO_y$), hafnium aluminum oxide ($HfAl_xO_y$), praseodymium oxide ($Pr_2O_3$) or a combination thereof.

The channel pad 144 may be on the channel layer 140 and/or the gate dielectric layer 150. The channel pad 144 may cover an upper surface of the core insulation layer 142 and be electrically connected to the channel layer 140. Although the channel pad 144 is shown covering an upper surface of the gate dielectric layer 150, it is not limited thereto. In an implementation, the channel pad 144 may not cover the upper surface of the gate dielectric layer 150, and instead, side surfaces of the channel pad 144 may be surrounded by the gate dielectric layer 150. The side surface of the channel pad 144 may be in contact with the tunneling layer 152. The channel pad 144 may include a conductive material, e.g., polysilicon doped with impurities. The material of the channel pad 144, however, is not limited thereto and may be variously changed.

As described above, when the gate stack structure 120 includes the plurality of gate stack structures 120a and 120b stacked on each other, each of the channel structures CH may be provided with the plurality of channel structures CH1 and CH2 that penetrate the plurality of gate stack structures 120a and 120b, respectively. In an implementation, when the plurality of gate stack structures 120 include the first gate stack structure 120a and the second gate stack structure 120b, each of the plurality of channel structures CH may include a first channel structure CH1 extended to penetrate the first gate stack structure 120a, and a second channel structure CH2 extended to penetrate the second gate stack structure 120b.

within each channel structure CH, the first channel structure CH1 and the second channel structure CH2 may have a form connected to each other. In a cross-sectional view, each of the first channel structure CH1 and the second channel structure CH2 may have an inclined side surface having a width that narrows as it approaches the second substrate 110 according to the aspect ratio. As shown in FIG. 2A, a bent portion may be provided due to a difference in width at a portion where the first channel structure CH1 and the second channel structure CH2 are connected. In another implementation, as shown in FIG. 2B, the first channel structure CH1 and the second channel structure CH2 may have an inclined side surface that is continuously connected without the bent portion. However, the shapes of the first channel structure CH1 and the second channel structure CH2 are not limited thereto and may be variously changed.

In FIG. 1, an integral structure formed by extending the gate dielectric layer 150, the channel layer 140, and the core insulation layer 142 of the first channel structure CH1 and the second channel structure CH2 is shown, as an example. The above-described structure may be formed by forming the gate dielectric layer 150, the channel layer 140, and the core insulation layer 142 entirely over first and second penetration portions after forming a first penetration portion for the first channel structure CH1 and a second penetration portion for the second channel structure CH2. However, the embodiments are not limited thereto. As another example, the gate dielectric layer 150, the channel layer 140, and the core insulation layer 142 of the first channel structure CH1 and the second channel structure CH2 may be separately formed and electrically connected to each other. In an implementation, the gate dielectric layer 150, the channel layer 140, and the core insulation layer 142 in the first penetration portion may be formed after forming the first penetration portion for the first channel structure CH1, and the gate dielectric layer 150, the channel layer 140, and the core insulation layer 142 in the second penetration portion may be formed after forming the second penetration portion for the second channel structure CH2. Various other modifications are available.

In an embodiment, the channel pad 144 may be provided on the channel structure CH, e.g., the second channel structure CH2, provided in the gate stack structure 120, e.g., the second gate stack structure 120b, positioned in an upper portion among the plurality of gate stack structures 120. Alternatively, the channel pad 144 may be provided in the first channel structure CH1 and the second channel structure CH2, respectively. In this case, the channel pad 144 of the first channel structure CH1 may be connected to the channel layer 140 of the second channel structure CH2.

In an embodiment, the gate stack structure 120 may be partitioned into a plurality on a plane by a separation structure 146 extending in a direction crossing or intersecting with the second substrate 110, e.g., the vertical direction, Z-axis direction in the drawing, to penetrate the gate stack structure 120.

In an implementation, the separation structure 146 may penetrate the gate electrodes 130 and the cell insulation layers 132 and extend to the second substrate 110. In a plan view, the separation structure 146 may extend in a first direction (Y-axis direction in the drawing), and may be provided in a plural quantity being spaced apart from each other at predetermined intervals in a crossing direction (X-axis direction in the drawing) crossing the first direction. The first direction may be a direction parallel to an upper surface of at least one of the first substrate 201 and the second substrate 110. The crossing direction may be a direction parallel to an upper surface of at least one of the first substrate 201 and the second substrate 110. Accordingly, in a plan view, the plurality of gate stack structures 120 may extend in the first direction (Y-axis direction in the drawing), respectively, and may be spaced apart from each other at predetermined intervals in the crossing direction (X-axis direction in the drawing). The gate stack structure 120 partitioned by the separation structure 146 may constitute one memory cell block. However, the embodiments are not limited thereto, and the range of the memory cell block is not limited thereto.

In an implementation, in a cross-sectional view, the separation structure 146 may have an inclined side surface having a width that decreases toward the second substrate 110 due to a high aspect ratio. However, the embodiments are not limited thereto, and a side surface of the separation structure 146 may be perpendicular to the second substrate 110. FIG. 1 illustrates, as an example, that, in a cross-sectional view, the separation structure 146 has a continuous inclined side surface in the first gate stack structure 120a and the second gate stack structure 120b and is not provided with the bent portion. However, the embodiments are not limited thereto, and the separation structure 146 may be provided with the bent portion in the boundary portion between the first gate stack structure 120a and the second gate stack structure 120b.

The separation structure 146 may be filled with various insulating materials. In an implementation, the separation structure 146 may include an insulating material such as silicon oxide, silicon nitride, or silicon nitride oxide. However, the embodiments are not limited thereto, and the structure, shape, and material of the separation structure 146 may be variously changed.

In addition, an upper separation pattern 148 may be in an upper portion of the gate stack structure 120. In a plan view, the upper separation pattern 148 may extend in the first direction (Y-axis direction in the drawing), and may be provided in a plural quantity being spaced apart from each other at predetermined intervals in the crossing direction (X-axis direction in the drawing) crossing the first direction.

The upper separation pattern 148 may penetrate one or a plurality of gate electrodes 130 including the upper gate electrode 130U positioned between the separation structures 146. The upper separation pattern 148 may separate, for example, three gate electrodes 130 from each other in the crossing direction (X-axis direction in the drawing). However, the number of gate electrodes 130 separated by the upper separation pattern 148 is not limited thereto and may be variously changed. The upper isolation pattern 148 may have a shape filled with an insulating material. In an implementation, the upper separation pattern 148 may include an insulating material such as silicon oxide, silicon nitride, or silicon nitride oxide. However, the embodiments are not limited thereto, and the structure, shape, and material of the upper separation pattern 148 may be variously changed.

In order to connect the gate stack structure 120 and the channel structure CH provided in the cell array region 102 to the circuit region 200 or external circuit, the contact region 104 and the second wire portion 180 may be provided.

Here, the second wire portion 180 may include all members configured to electrically connect the gate electrode 130, the channel structure CH, the horizontal conductive layers 112 and 114 and/or the second substrate 110 to the circuit region 200 or external circuit. In an implementation, the second wire portion 180 may include a bit line 182, the gate contact portion 184a, a source contact portion 186, a penetration plug 188 and contact vias 180a connected thereto respectively, and a connection wire 190 configured to connect them.

The bit line 182 may be positioned on the cell insulation layer 132 of the gate stack structure 120 disposed on the cell array region 102. The bit line 182 may extend in the crossing direction (X-axis direction in the drawing) crossing the first direction in which the gate electrode 130 extends. The bit line 182 may be electrically connected to the channel structure CH, e.g., the channel pad 144, through the contact via 180a, e.g., bit line contact via.

The contact region 104 may be adjacent the cell array region 102. A portion of the second wire portion 180 may be in the contact region 104. The contact region 104 may include the gate pattern stack structure 210 positioned on the first substrate 201, and the gate contact portion 184a configured to connect the gate electrodes 130 of the cell array region 102 to the circuit region 200 or external circuit.

Referring to FIG. 3, the gate pattern stack structure 210 may be formed by repeating sequential stacking of insulation layers 231 and 232 and a gate pattern 230(R, C, T, T) on the second substrate 110, e.g., on the second horizontal conductive layer 114 on the second substrate 110. In an implementation, the insulation layers 231 and 232 may include first insulation layers 231 and second insulation layers 232. The gate patterns 230(R, C, T, T), the second insulation layers 232 and the first insulation layers 231 may be sequentially stacked repeatedly.

In an embodiment, the gate pattern stack structure 210 may include a plurality of gate pattern stack structures 210a and 210b sequentially stacked on the second substrate 110. In an implementation, when the gate stack structure 120 includes the first and second gate stack structures 120a and 120b, the gate pattern stack structure 210 includes first and second gate pattern stack structures 210a and 210b. In this case, the number of gate patterns 230 stacked on the first and second gate pattern stacking structures 210a, 210b may correspond to the number of gate electrodes 130. However, the embodiments are not limited thereto, and the gate pattern stack structure 210 may include one gate pattern stack structure or three or more gate pattern stack structures.

The gate patterns 230 may correspond to the gate electrodes 130 of the gate stack structure 120. In an implementation, the number of gate patterns 230 may be equal to the number of gate electrodes 130. In addition, each of the gate patterns 230 may have a structure integrated with a corresponding gate electrode 130. Here, to have a structure integrated with a gate electrode may mean to be formed of continuous layers formed together in the same process and of the same material. That is, in the process of forming the gate electrodes 130, the gate patterns 230 are also formed using the same material. As such, the gate patterns 230 may be electrically connected to the gate electrodes 130.

Each gate pattern 230 may extend along the first direction (Y-axis direction in the drawing) from a first end of the corresponding gate electrode 130. Extension lengths of the gate patterns 230 may be substantially the same. In an implementation, lengths of the gate patterns 230 extending in the first direction (Y-axis direction in the drawing) may be substantially the same. That is, edges of the plurality of gate patterns 230 may be aligned on the same boundary. Accordingly, a side surface of the gate pattern stack structure 210 may be aligned in the vertical direction (Z-axis direction in the drawing) perpendicular to the second substrate 110.

A second insulation layer 232 and a first insulation layer 231 may be sequentially positioned on each gate pattern 230. With reference to one gate pattern 230(R, C, T, T), a first insulation layer 231 may be positioned on a lower surface of the gate pattern 230(R, C, T, T) and a second insulation layer 232 may be positioned on an upper surface of the gate pattern 230(R, C, T, T). However, the embodiments are not limited thereto, and the first insulation layer 231 and the second insulation layer 232 may be sequentially positioned on the gate pattern 230.

One of the first insulation layers 231 and one of the second insulation layers 232 may be in contact with a first side of the interlayer insulation layer 132m. That is, the one of the first insulation layers 231 and the one of the second insulation layers 232 may correspond to the interlayer insulation layer 132m. In an implementation, the number of the first insulation layers 231 may be equal to the number of the interlayer insulation layers 132m. The number of the second insulation layers 232 may be equal to the number of the interlayer insulation layers 132m.

Extension lengths of the first insulation layers 231 the second insulation layers 232 may be substantially the same. In an implementation, lengths of the first insulation layers 231 and the second insulation layers 232 extend in the first direction (Y-axis direction in the drawing) may be substantially the same. That is, edges of the first insulation layers 231 may be aligned on the same boundary. Edges of the second insulation layers 232 may be aligned on the same boundary. In addition, edges of the first insulation layers 231, the second insulation layers 232, and the gate patterns 230 may be aligned on the same boundary. Accordingly, the side surface of the gate pattern stack structure 210 may be aligned in the vertical direction (Z-axis direction in the drawing) perpendicular to the second substrate 110.

In an embodiment, an upper surface of one of the first insulation layers 231 may be at substantially the same level as an upper surface of one of the interlayer insulation layers 132m. A lower surface of one of the second insulation layers 232 may be positioned at substantially the same level as a lower surface of the one of the interlayer insulation layers 132m. That is, the thickness along the vertical direction (Z-axis direction in the drawing) perpendicular to the second substrate 110 of the interlayer insulation layer 132m may be substantially the same as a sum of the thickness along the vertical direction (Z-axis direction in the drawing) perpendicular to the second substrate 110 of the first insulation layer 231 and the thickness along the vertical direction (Z-axis direction in the drawing) perpendicular to the second substrate 110 of the second insulation layer 232. However, it is not limited thereto, and the relationship between the thicknesses of the interlayer insulation layers 132m, the first insulation layers 231, and the second insulation layers 232 may be variously changed within the case that a first side surface of each gate electrode 130 is in contact with a first side surface of each gate pattern 230.

The thickness of the second insulation layer 232 may be less than the thickness along the vertical direction (Z-axis direction in the drawing) perpendicular to the second substrate 110 of the interlayer insulation layer 132m. In the vertical direction (Z-axis direction in the drawing) perpendicular to the second substrate 110, a thickness T2 of the second insulation layer 232 may be smaller than a thickness of the first insulation layer 231 or a thickness of the gate pattern 230. This is because the second insulation layer 232 is a layer for detecting an end point detection (EPD) signal during an etching process, and may have a relatively small thickness.

In an implementation, the second thickness T2 of the second insulation layer 232 may be 1/100 to 1/10 of the thickness of the interlayer insulation layer 132m. In addition, the second thickness T2 of the second insulation layer 232 may be 1/99 to 1/9 of the sum of the thicknesses of the first insulation layer 231 and the gate pattern 230. This range of the second insulation layer 232 may properly adjust the timing at which the second insulation layer 232 is exposed during the process of etching the gate pattern stack structure 210 and efficiently control the etching process time. However, the embodiments are not limited thereto, and the thickness of the second insulation layer 232 may be variously modified.

The first insulation layers 231 may include various insulating materials. The same material as the cell insulation layers 132 may be included. In an implementation, the first insulation layers 231 may include silicon oxide, silicon nitride, silicon nitride, a low permittivity material having a lower dielectric constant than silicon oxide, or a combination thereof.

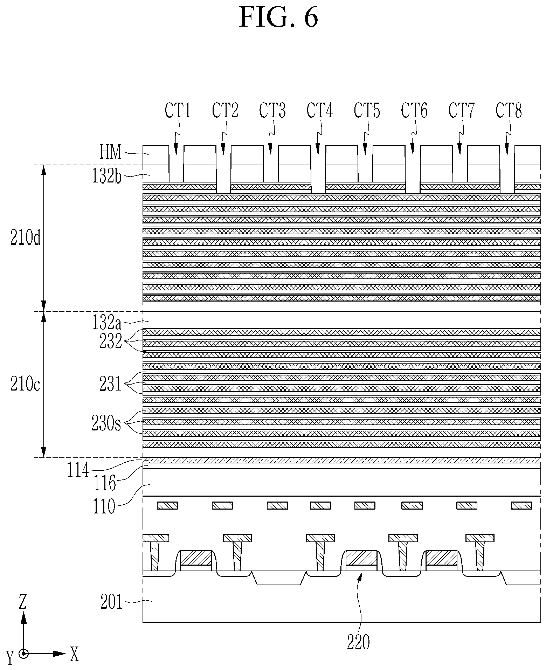

The second insulation layers 232 may include a material different from that of the first insulation layers 231. In addition, the second insulation layers 232 may include a material different from that of the interlayer insulation layers 132m. The second insulation layers 232 may include a material for detecting an end point of an etching process in the process of forming a contact hole CT by etching a portion of the gate pattern stack structure 210. Accordingly, the second insulation layers 232 may be used as etch stop layers in the process of forming contact holes CT. In addition, the second insulation layers 232 may include a material having an etch selectivity with respect to the sacrificial insulation layers (reference numeral 230s in FIG. 6, the same hereinbelow) and the first insulation layers 231.

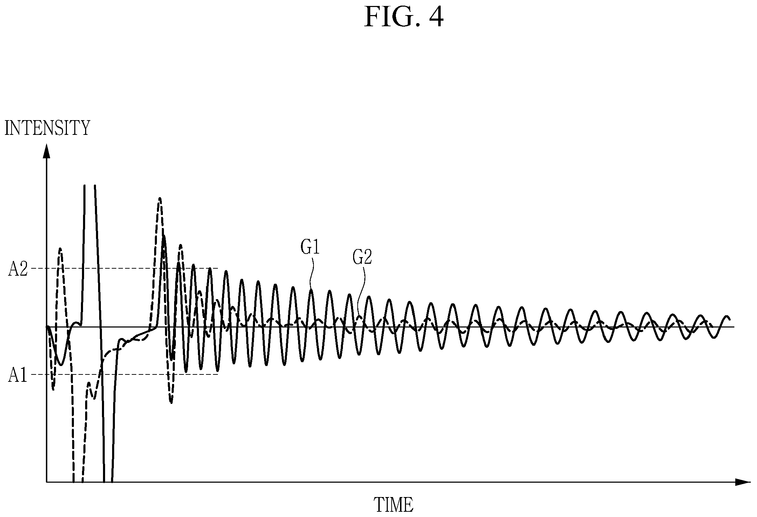

Here, the process of forming the contact hole CT may be controlled by using an EPD method. The EPD method is a method of detecting an end point of an etching process by monitoring an etching state during the etching process. This will be described later with reference to FIG. 4. The arrangement of a contact hole CT, a first insulation layer 231, a second insulation layer 232 and a sacrificial layer 230s is described; however, it will be appreciated that this description may equally apply to other contact holes, first insulation layers, second insulation layers and sacrificial layers.

The second insulation layer 232 may include a detection element. The detection element may be a particular element (e.g. chemical element) for detecting an EPD signal in an etching reaction gas to be described later. At this time, the first insulation layer 231 and the sacrificial insulation layer 230s may not include a detection element. Accordingly, the detection element is included in the etching reaction gas generated by etching the second insulation layer 232, and the detection element may not be included in the etching reaction gas generated by etching the first insulation layer 231 and the sacrificial insulation layer 230s. Therefore, the detection element may be detected by an EPD signal. This will be described later with reference to FIG. 4.

The second insulation layer 232 may include an element or isotope thereof not included in the first insulation layer 231 and/or the sacrificial insulation layer 230s, or may include an organic polymer.

In an implementation, the detection element may include at least one of carbon, boron, fluorine, potassium, or combination thereof. In an implementation, when the detection element includes carbon, the second insulation layer 232 may include at least one of silicon carbonate, silicon carbonate nitride, silicon carbonitride, carbon doping oxide. In an implementation, the second insulation layer 232 may include an oxide doped with the detection element. Fluorine-doped oxide (fluorine-doped oxide or FSG), carbon-doped oxide, hydrogen silsesquioxane (HSQ; SiO:H), and the like may be used as the oxide doped with the detection element.

Alternatively, the detection element includes a metal containing a different metal from the metal contained in the gate pattern 230, and the second insulation layer 232 is made of a metal compound containing the above-mentioned metal or a compound doped with the above-mentioned metal. In an implementation, the second insulation layer 232 may include at least one of gold, platinum, calcium, titanium, or a combination thereof as a metal. The second insulation layer 232 may include a metal oxide, a metal nitride, a metal oxynitride, a metal oxycarbide, a metal carbonate nitride, a metal carbonitride, and the like that includes the above-described metal.

Alternatively, the detection element may include an isotope. In an implementation, the detection element may include isotopes of carbon, boron, fluorine, potassium, and the like. Alternatively, the detection element may include an isotope of an element constituting the first insulation layer 231 or the sacrificial insulation layer 230s. In an implementation, the detection element may include isotopes of oxygen, nitrogen, and the like. Even if the first insulation layer 231 or the sacrificial insulation layer 230s includes a particular element, e.g., oxygen or nitrogen or the like, since the second insulation layer 232 includes an isotope of the particular element, e.g., oxygen or nitrogen or the like, the detection element may be detected by the EPD signal.

Alternatively, the second insulation layer 232 may include an organic polymer. In an implementation, polyallylether-based resin, cyclic fluororesin, siloxane copolymer, fluorinated polyallyl ether-based resin, polypentafluorostylene, polytetrafluorostyrene-based resin, fluorinated polyimide resin, polynaphthalene fluoride, polycide resin, and the like may be used as an organic polymer.

Organic polymers include fluorinated polyimide resins.

In an embodiment, the second insulation layer 232 may include a low permittivity material having a dielectric constant lower than that of the first insulation layer 231 or lower than that of silicon oxide. The second insulation layer 232 may include the oxide doped with the detection element or may include an organic polymer. When the second insulation layer 232 includes, among the above-described materials, fluorine-doped oxide, carbon-doped oxide, HSQ, polyallylether-based resin, cyclic fluororesin, siloxane copolymer, fluorinated polyallyl ether-based resin, polypentafluorostylene, polytetrafluorostyrene-based resin, fluorinated polyimide resin, polynaphthalene fluride, polycide resin, it may have a low permittivity. As such, when the second insulation layer 232 positioned between the gate patterns 230 has a low permittivity, parasitic capacitance between the vertically stacked gate patterns 230 may be reduced during operation of the semiconductor device.

However, it is not limited thereto, and the detection element may be variously changed to an element different from an element constituting the first insulation layer 231 and the sacrificial insulation layer 230s.

In the contact region 104, the gate contact portion 184a may pass through at least a portion of the gate pattern stack structure 210 and be connected to the gate pattern 230.

In further detail, each gate contact portion 184a passes through a through-gate pattern 230T, which is at least a portion of the plurality of gate patterns 230, and may be electrically connected to a connection gate pattern 230C positioned in a lower portion of the through-gate pattern 230T. The through-gate pattern 230T may comprise one or more of the plurality of gate patterns 230, at an upper portion of the gate pattern stack structure 210. The gate contact portion 184a may be positioned within the contact hole CT. A lower surface of the gate contact portion 184a may be in contact with a portion of an upper surface of the connection gate pattern 230C. Here, with respect to one gate contact portion 184a, among the plurality of gate patterns 230, the gate pattern 230 through which the gate contact portion 184a passes is referred to as a through-gate pattern 230T, and the gate pattern 230 connected to the gate contact portion 184a is referred to as the connection gate pattern 230C.

The gate contact portion 184a may have a column shape in cross section. In an implementation, in a cross-sectional view, the gate contact portion 184a may have an inclined side surface having a width that narrows as it approaches the second substrate 110 according to the aspect ratio. However, the embodiments are not limited thereto, and the arrangement, structure, and shape of the gate contact portion 184a may be variously changed.

In an embodiment, each of the gate contact portions 184a is electrically connected to a corresponding connection gate pattern 230C. Each of the gate contact portions 184a may be connected to a different connection gate pattern 230C. The through-gate pattern 230T positioned in an upper portion of the gate pattern stack structure 210 (e.g. above the connection gate pattern 230C) and one or more remaining gate patterns 230R positioned in a lower portion of the gate pattern stack structure 210 (e.g. below the connection gate pattern 230C) may be electrically insulated from the gate contact portion 184a. The through-gate pattern 230T positioned in the upper portion of the gate pattern stack structure 210 is penetrated by the gate contact portion 184a, and the through-gate pattern 230T may be insulated from the gate contact portion 184a through a gate spacer 184b. The through-gate pattern 230T positioned in the upper portion of the gate pattern stack structure 210 may be in contact with the gate spacer 184b.

The remaining gate patterns 230R positioned in the lower portion of the gate pattern stack structure 210 may not be penetrated by the gate contact portion 184a. Therefore, since the remaining gate patterns 230R positioned in the lower portion of the gate pattern stack structure 210 are spaced apart from the gate contact portion 184a, they may be insulated from the gate contact portion 184a.

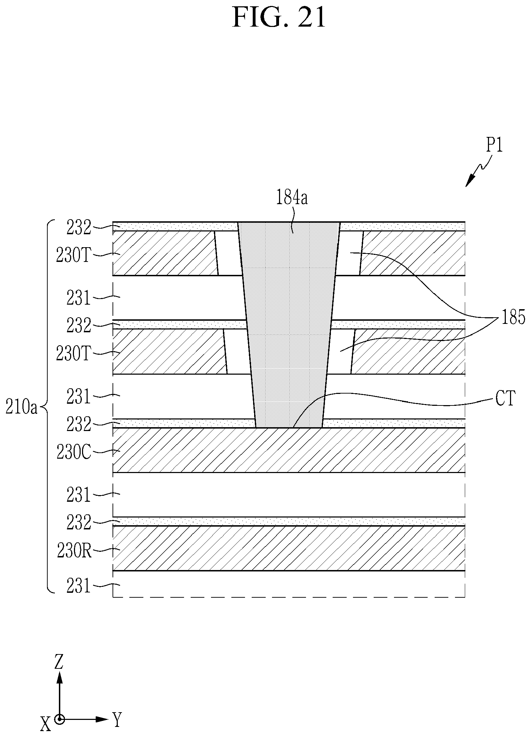

The gate spacer 184b may surround the gate contact portion 184a, e.g., a side surface of the gate contact portion 184a. In an implementation, the gate contact portion 184a may have a columnar shape (e.g., a cylindrical shape or a polygonal columnar shape), and the gate spacer 184b may have a planar shape such as an annular shape. The gate spacer 184b may overlap the gate contact portion 184a at an outer portion of the contact hole CT. The gate spacer 184b may be positioned on a sidewall of the contact hole CT. However, the embodiments are not limited thereto, and the gate spacer 184b may have a ring shape and may surround some side surfaces of the gate contact portion 184a. This will be described later with reference to FIG. 21.

The gate spacer 184b may be positioned such that the gate contact portion 184a is electrically connected to the connection gate pattern 230C and insulated from the through-gate pattern 230T. In an implementation, the gate spacer 184b may not be positioned on the lower surface of the gate contact portion 184a. That is, the gate spacer 184b may not be positioned between the gate contact portion 184a and the connection gate electrode.

The gate spacer 184b may be in contact with the connection gate pattern 230C. In an implementation, a lower surface of the gate spacer 184b may be in contact with the upper surface of the connection gate pattern 230C. Therefore, the lower surface of the gate spacer 184b may be aligned on the same boundary as the lower surface of the gate contact portion 184a. That is, the lower surface of the gate spacer 184b and the lower surface of the gate contact portion 184a may be positioned at substantially the same level. According to this, the gate spacer 184b surrounds the entire side surface of the gate contact portion 184a and effectively insulates the gate contact portion 184a from the adjacent gate pattern 230.

The gate spacer 184b may include various insulating materials. In an implementation, the gate spacer 184b may include silicon oxide, silicon nitride, silicon nitride, a low permittivity material having a lower dielectric constant than silicon oxide, or a combination thereof.

Although the gate spacer 184b is shown as a single layer in FIG. 1 and FIG. 3, the embodiments are not limited thereto, and a layer inevitably formed between the gate spacer 184b and the gate contact portion 184a may exist or a separate layer may be further provided.

Referring back to FIG. 1, in the contact region 104, the source contact portion 186 penetrates the cell insulation layer 132 and is electrically connected to the horizontal conductive layers 112 and 114 and/or the second substrate 110, and the penetration plug 188 is disposed in an outer side of the gate pattern stack structure 210 and may be electrically connected to the first wire portion 240 of the circuit region 200. However, it is not limited thereto, and the penetration plug 188 may penetrate the gate pattern stack structure 210 and may be electrically connected to the first wire portion 240 of the circuit region 200.

The connection wire 190 may be positioned in the cell array region 102 and/or the contact region 104. The bit line 182, the gate contact portion 184a, the source contact portion 186 and/or the penetration plug 188 may be electrically connected to the connection wire 190. In an implementation, the gate contact portion 184a, the source contact portion 186 and/or the penetration plug 188 may be connected to the connection wire 190 through the contact via 180a.

FIG. 1 illustrates that the connection wire 190 is provided as a single layer located on the same plane as the bit line 182, and the second wire insulation layer 192 is located in a portion other than the second wiring unit 180. However, this is merely a brief illustration shown for convenience. Accordingly, the connection wire 190 may include a plurality of wire layers for electrical connection with the bit line 182, the gate contact 184a, the source contact 186, and/or the through plug 188, and may further includes contact vias.

As described above, by the second wire portion 180 and the first wire portion 240, the bit line 182, the gate electrode 130, the horizontal conductive layers 112 and 114 and/or the second substrate 110 connected to the channel structure CH may be electrically connected to the circuit element 220 of the circuit region 200.

FIG. 1 illustrates that, in a cross-sectional view, the source contact portion 186 and/or the penetration plug 188 has an inclined side surface having a width that narrows as it approaches the second substrate 110 according to the aspect ratio, and the bent portion is provided in the boundary portion between the first gate stack structure 120a and the second gate stack structure 120b. However, the embodiments are not limited thereto. In an implementation, it is also possible that the source contact portion 186 and/or the penetration plug 188 is not provided with the bent portion at the boundary portion between the first gate stack structure 120a and the second gate stack structure 120b. Various other modifications are available.

In a semiconductor device according to an embodiment, the gate pattern stack structure 210 includes the second insulation layer 232, and an etching process for forming the contact hole CT may be easily controlled. In addition, the second insulation layer 232 may have a low permittivity, and parasitic capacitance between the vertically stacked gate patterns 230 may be reduced during operation of the semiconductor device. Accordingly, reliability and productivity of the semiconductor device 10 may be enhanced.

Referring to FIG. 4, a second insulation layer of a semiconductor device according to an embodiment will be described.

FIG. 4 is a graph showing the intensity of light for the detection element over time in an etching process.

In the EPD method, the detection element may be detected by measuring the intensity of light of a specific wavelength corresponding to the detection element. Accordingly, the position of the second insulation layer 232 may be detected by using the point at which the intensity of light with respect to the detection element is the peak as an EPD signal.

In FIG. 4, a solid line is a graph showing the intensity of light for the detection element. In FIG. 4, a dotted line is a graph showing the intensity of light for carbon used to detect an end point in a conventional EPD method for comparison.

Referring further to FIG. 4, in order to electrically connect the gate contact portion 184a to the gate pattern 230, contact holes CT having different heights may be formed in the gate pattern stack structure 210. At this time, the process of forming the contact hole CT may be controlled by using an EPD method. The EPD method is a method of detecting an end point of an etching process by monitoring the intensity of light for a certain element during an etching process.

As described above, the second insulation layer 232 may include a detection element different from that of the first insulation layer 231, and the first insulation layer 231 and the sacrificial insulation layer 230s may not include the detection element. Accordingly, the intensity of light of the detection element in the reaction gas increases, such that the EPD signal is detected, and the location of the second insulation layer 232 may be detected by the EPD signal. Specifically, in the case of a dry etching process using plasma, the EPD signal may be detected by observing a change in the characteristics of a reaction gas. For example, the type and amount of the detection element included in the reaction gas may vary depending on the type and amount of the detection element present in the material layer to be etched.

As a process of forming the contact hole CT, each of the sacrificial insulation layers 230s, the second insulation layers 232, and the first insulation layers 231 that are sequentially and repeatedly stacked may be etched by the same etchant. At this time, the first insulation layers 231 may discharge first etching reaction gas, the sacrificial insulation layers 230s may discharge second etching reaction gas, and the second insulation layers 232 may discharge third etching reaction gas. Accordingly, a first EPD signal G1 may be detected by measuring the detection element included in the first to third etching reaction gases according to time.

At this time, the gate pattern stack structure 210 may include the periodically stacked second insulation layers 232, and the second insulation layers 232 may be periodically etched. Accordingly, the intensity of light with respect to the detection element may be a waveform that oscillates according to a period. One period may be defined as the time from one peak to the next peak, for example.

In an embodiment, the intensity of light with respect to the detection element may have a peak at each period. The peak is a point having the highest value in each period and may be a point at which the detection element is detected in the etching reaction gas. Accordingly, the second insulation layer 232 may be detected from the peak of the first EPD signal G1.

When the first EPD signal G1 is detected, the etching process may be stopped. In this case, the second insulation layer 232 may be exposed in the contact hole CT. By including the detection element in the second insulation layer 232, a stopping point at which the second insulation layer 232 is etched may be accurately detected. By counting the number of peaks, the etching may be stopped at an appropriate level/layer within the gate pattern stack structure 210. Thus, the etching process may be easily controlled.

However, as the gate pattern stack structure 210 is etched, the difference between the peak A2 and the lowest point A1 (the amplitude) may gradually decrease.

As shown by the dotted line in FIG. 4, conventionally, a second EPD signal G2 has been detected using carbon. In the same period, the magnitude of the second EPD signal G2 may be smaller than that of the first EPD signal G1. In an embodiment, the second insulation layer 232 may include the detection element in an amount sufficient for detection so as to effectively detect the EPD signal G1, but in alternative examples, carbon is a material formed as a by-product of an etching process, but is not included in a second insulation layer 232, and is therefore insufficient for detection, particularly at lower levels.

In addition, when the number of gate patterns 230 stacked in the gate pattern stack structure 210 increases, the second EPD signal G2 may become very small. That is, when the number of stacked gate patterns 230 increases, it may be difficult to accurately detect the second EPD signal G2.

On the other hand, since the second insulation layer 232 includes the detection element, the magnitude of the first EPD signal G1 may not significantly decrease even when the number of gate patterns 230 increases. That is, as the number of stacked gate patterns 230 increases, the first EPD signal G1 may continue to be accurately detected.

Therefore, since the gate pattern stack structure 210 according to an embodiment includes the second insulation layer 232, the EPD signal may be easily detected, and the etching process may be easily controlled. In addition, even if the number of gate patterns 230 increases, the level of signal values of the EPD signal may not decrease. Therefore, the etching process may be accurately stopped at a desired position, and the contact holes CT having different heights may be stably formed.

However, the embodiments are not limited thereto, and the method of detecting the EPD signal may include a method of detecting an isotope included in the second insulation layer 232, or detecting a density or intensity distribution or the like of a particular element included in the reaction gas.

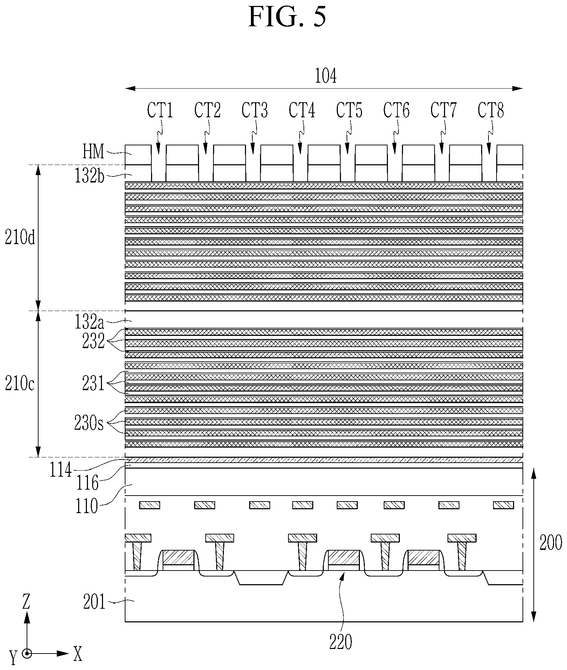

Hereinafter, a method of manufacturing a semiconductor device according to an embodiment will be described with reference to FIGS. 5 to 16.

FIGS. 5 to 16 are cross-sectional views sequentially illustrating and showing a process in a method of manufacturing a semiconductor device according to an embodiment. In FIGS. 5 to 16, only the contact region 104 is shown for convenience, and the cell array region is omitted. Hereinafter, a method for manufacturing a contact region of a semiconductor device according to an embodiment will be described.

Referring to FIG. 5, stack structures 210c and 210d are formed on the circuit region 200 including the peripheral circuit structure.

First, the sacrificial insulation layers 230s, the second insulation layers 232, and the first insulation layers 231 may be sequentially and repeatedly stacked to form a first stack structure 210c as a lower structure. In an uppermost portion of the first stack structure 210c, the first upper insulation layer 132a may be positioned on an uppermost second insulation layer 232. The second substrate 110, the horizontal insulation layer 116, the second horizontal conductive layer 114 and the like may be further formed between the circuit region 200 and the first stack structure 210c.

The horizontal insulation layer 116 and/or the sacrificial insulation layers 230s may be formed of a material different from that of the first insulation layers 231. In an implementation, the first insulation layers 231 may include silicon oxide, silicon nitride, silicon nitride oxide, low permittivity material, and the like, and the sacrificial insulation layers 230s may include one of silicon, silicon oxide, silicon carbide, silicon nitride and may be formed of a material different from that of the first insulation layers 231.

Then, the sacrificial insulation layers 230s, the second insulation layers 232, and the first insulation layers 231 may be alternately stacked on the first stack structure 210c, and thereby a second stack structure 210d as an upper structure may be formed. In an uppermost portion of the second stack structure 210d, the second upper insulation layer 132b may be positioned on an uppermost second insulation layer 232. A method and the like of manufacturing the sacrificial insulation layers 230s, the second insulation layers 232, the first insulation layers 231, the second upper insulation layer 132b and the like of the second stack structure 210d may be the same as the case of the first stack structure 210c, and a description thereof is omitted. Although the process drawings show that the stack structures 210c and 210d are formed of two stack structures, it is not limited thereto, and the stack structures 210c and 210d may be made of one stack structure, and may include three or more stack structures.

Each sacrificial insulation layer 230s may be a layer replaced with a gate pattern (230 in FIG. 1) in a subsequent process. That is, the sacrificial insulation layer 230s may be formed to correspond to a portion where the gate pattern (230 in FIG. 1) is to be formed.

Subsequently, a hard mask HM may be formed on the second stack structure 210d, and contact holes CT1 to CT8 penetrating the hard mask HM and the second upper insulation layer 132b may be formed.

Lower surfaces of the contact holes CT1 to CT8 may be positioned in an upper surface of the second insulation layer 232 in an uppermost portion (e.g. an uppermost second insulation layer 232). In an implementation, the contact holes CT1 to CT8 may be formed using an etching process using the uppermost second insulation layer 232 as an etch stop layer.

Referring to FIG. 6, the second stack structure 210d exposed through the second, fourth, sixth, and eighth contact holes CT2, CT4, CT6, and CT8 are partially etched. In an implementation, one layer of the second insulation layers 232, one layer of the sacrificial insulation layers 230s, and one layer of the first insulation layers 231 may be etched. The second, fourth, sixth, and eighth contact holes CT2, CT4, CT6, and CT8 may extend downward.

In this case, as described above, the second insulation layers 232 may include the detection element, and the first insulation layers 231 and the sacrificial insulation layers 230s may not include the detection element. Accordingly, as described above, the EPD signal may be detected by measuring the detection element included in the etching reaction gas. The etching process may be stopped at the time point where the calculated EPD signal is detected. The second insulation layers 232 may be etched more slowly than the first insulation layers 231 and the sacrificial insulation layers 230s. In other words, the second insulation layers 232 may include a material having an etch selectivity with respect to the first insulation layers 231 and the sacrificial insulation layers 230s. For instance, the second insulation layers 232 may include a material that is etched at a slower rate than the first insulation layers 231 and the sacrificial insulation layers 230s (e.g. for a particular etchant).

Accordingly, the second, fourth, sixth, and eighth contact holes CT2, CT4, CT6, and CT8 may expose the upper surface of the second insulation layer 232. Lower surfaces of the second, fourth, sixth, and eighth contact holes CT2, CT4, CT6, and CT8 may be lower than those of FIG. 5.

The process of partially etching the second stack structure 210d exposed through the second, fourth, sixth, and eighth contact holes CT2, CT4, CT6, and CT8 may be etched by forming a photoresist pattern exposing the second, fourth, sixth, and eighth contact holes CT2, CT4, CT6, and CT8 on the hard mask HM and performing etching using the photoresist pattern.

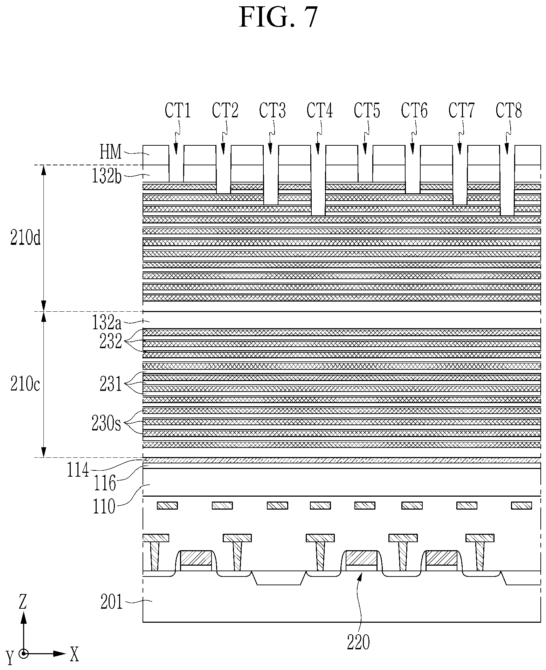

Referring to FIG. 7, the second stack structure 210d exposed through the third, fourth, seventh, and eighth contact holes CT3, CT4, CT7, and CT8 are partially etched. In an implementation, two layers of the second insulation layers 232, two layers of the sacrificial insulation layers 230s, and two layers of the first insulation layers 231 may be etched. The third, fourth, seventh, and eighth contact holes CT3, CT4, CT7, and CT8 may extend downward.

At this time, the EPD signal may be detected by measuring the detection element included in the etching reaction gas, and the etching process may be stopped at the time point where the calculated EPD signal is detected. A description thereof is substantially the same as that of FIG. 5, and thus will be omitted.

Accordingly, the third, fourth, seventh, and eighth contact holes CT3, CT4, CT7, and CT8 may expose the upper surface of the second insulation layer 232. Lower surfaces of the third, fourth, seventh, and eighth contact holes CT3, CT4, CT7, and CT8 may be lower than those of FIG. 6. A lower level of a fourth contact hole CT4 may be positioned at a lower level than a lower surface of a third contact hole CT3. A lower surface of the third contact hole CT3 may be positioned at a lower level than a lower surface of a second contact hole CT2. A lower surface of the eighth contact hole CT8 may be positioned at a lower level than that of the seventh contact hole CT7. A lower surface of the seventh contact hole CT may be positioned at a lower level than that of the sixth contact hole CT6.

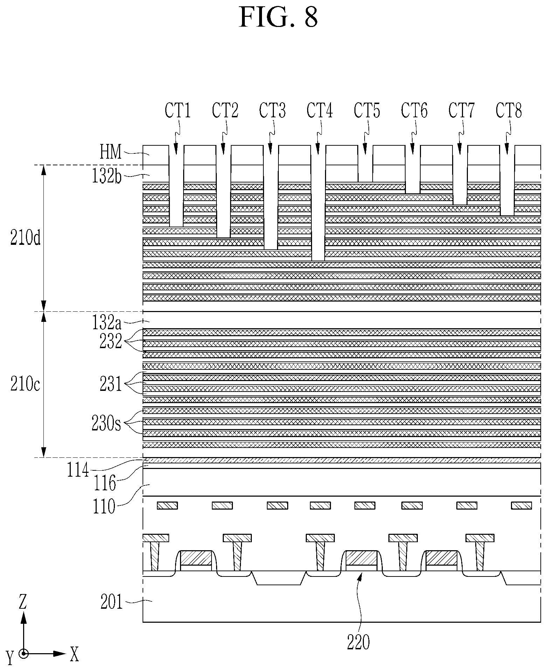

Referring to FIG. 8, the second stack structure 210d exposed through the first to fourth contact holes CT1 to CT4 are partially etched. In an implementation, four layers of the second insulation layers 232, four layers of the sacrificial insulation layers 230s, and four layers of the first insulation layers 231 may be etched. The first to fourth contact holes CT1 to CT4 may extend downward.

At this time, the EPD signal may be detected by measuring the detection element included in the etching reaction gas, and the etching process may be stopped at the time point where the calculated EPD signal is detected. A description thereof is substantially the same as that of FIG. 5, and thus will be omitted.

Accordingly, first to fourth contact holes CT1 to CT4 may expose the upper surfaces of corresponding (e.g. different) second insulation layers 232. Lower surfaces of first to fourth contact holes CT1 to CT4 may be lower than those of FIG. 7. Specifically, a lower surface of a first contact hole CT1 may be positioned at a lower level than a lower surface of each of fifth to eighth contact holes CT5 to CT8.

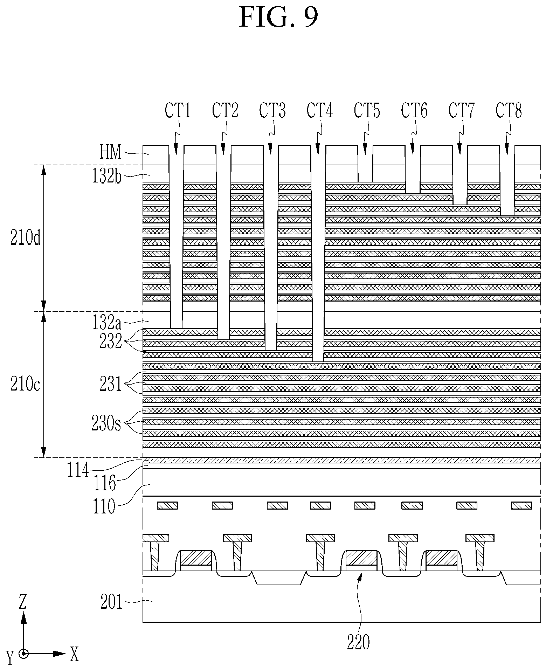

Referring to FIG. 9, portions of the second stack structure 210d and the first stack structure 210c exposed through the first to fourth contact holes CT1 to CT4 are etched. In an implementation, eight layers of the second insulation layers 232, eight layers of the sacrificial insulation layers 230s, and eight layers of the first insulation layers 231 may be etched. The first to fourth contact holes CT1 to CT4 may extend downward. However, although it has been described with reference to FIG. 9 that the second stack structure 210d and the first stack structure 210c exposed through the first to fourth contact holes CT1 to CT4 are partially etched, embodiments are not limited thereto. In an implementation, even when eight layers of the second insulation layers 232, the sacrificial insulation layers 230s, and the first insulation layers 231 exposed through the first to fourth contact holes CT1 to CT4 are etched, the first stack structure 210c may not be etched depending on the numbers of the second insulation layers 232, the sacrificial insulation layers 230s, and the first insulation layers 231 stacked in the second stack structure 210d.

At this time, the EPD signal may be detected by measuring the detection element included in the etching reaction gas, and the etching process may be stopped at the time point where the calculated EPD signal is detected. A description thereof is substantially the same as that of FIG. 5, and thus will be omitted.

Accordingly, first to fourth contact holes CT1 to CT4 may expose the upper surfaces of corresponding (e.g. different) second insulation layers 232. Lower surfaces of first to fourth contact holes CT1 to CT4 may be lower than those of FIG. 8. Specifically, a lower surface of the first contact hole CT1 may be positioned at a lower level than a lower surface of each of fifth to eighth contact holes CT5 to CT8.

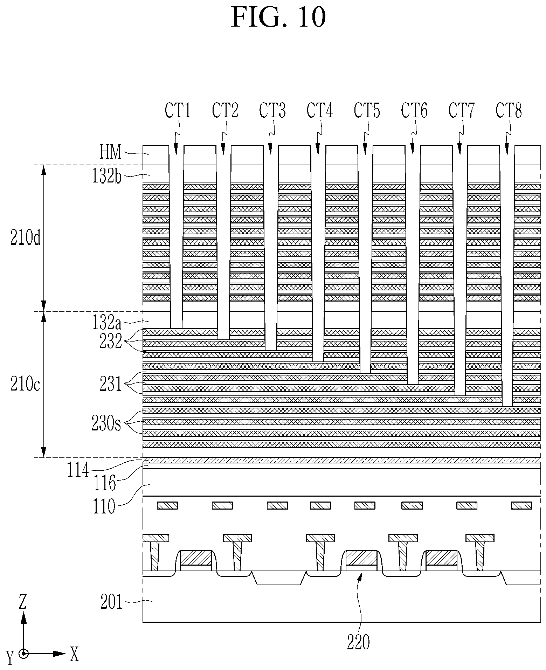

Referring to FIG. 10, portions of the second stack structure 210d and the first stack structure 210c exposed through the fifth to eighth contact holes CT5 to CT8 are etched. In an implementation, sixteen layers of the second insulation layers 232, sixteen layers of the sacrificial insulation layers 230s, and sixteen layers of the first insulation layers 231 may be etched. The fifth to eighth contact holes CT5 to CT8 may extend downward. However, although it has been described with reference to FIGS. 5 to 10 that the second stack structure 210d and the first stack structure 210c exposed through the fifth to eighth contact holes CT5 to CT8 are partially etched, embodiments are not limited thereto. In an implementation, even when sixteen layers of the second insulation layers 232, the sacrificial insulation layers 230s, and the first insulation layers 231 exposed through the fifth to eighth contact holes CT5 to CT8 are etched, the first stack structure 210c may not be etched depending on the second insulation layers 232, the sacrificial insulation layers 230s, and the number of the first insulation layers 231 stacked in the second stack structure 210d.

At this time, the EPD signal may be detected by measuring the detection element included in the etching reaction gas, and the etching process may be stopped at the time point where the calculated EPD signal is detected. A description thereof is substantially the same as that of FIG. 5, and thus will be omitted.

Accordingly, the fifth to eighth contact holes CT5 to CT8 may expose the upper surface of corresponding (e.g. different) second insulation layers 232. Lower surfaces of the fifth to eighth contact holes CT5 to CT8 may be lower than those of FIG. 9. That is, by performing the contact hole etching process five times, the first to eighth contact holes CT1 to CT8 may have different depths.

In FIG. 5 to FIG. 10, the number of contact holes CT1 to CT8 is illustrated as 8, but is not limited thereto and may vary according to the number of memory cell transistors. According to an embodiment, five contact hole etching processes are required in order to form first to eighth contact holes CT1 to CT8 corresponding to the eight stacked second insulation layers 232 in the contact region 104.

In general, the number of etching times required to form the contact holes CT contacting the N stacked sacrificial insulation layers 230s respectively follows Equation 1 below.

$$\text{(Equation 1)}$$
$$N \leq 2^{X-1}$$

In Equation 1, N is the number of sacrificial insulation layers 230s, which is an integer, and X is the number of contact hole etching processes, which is an integer.

For N and X, at least X times of contact hole etching processes may be performed to form the contact holes CT in respective contact with the N sacrificial insulation layers 230s. If contact hole etching processes are performed X number of times, sequentially $2^n$ (here, n is an integer satisfying $1 \leq n \leq X$) number of the second insulation layers 232, the sacrificial insulation layers 230s, and the first insulation layers 231 may be etched. In an implementation, 10 times of contact hole etching processes may be performed in order to form contact holes CT in contact with 500 sacrificial insulation layers 230s. When 10 times of contact hole etching processes are performed, a 1st contact hole etching process may etch one layer of second insulation layers 232, one layer of sacrificial insulation layers 230s, and one layer of first insulation layers 231. A 2nd contact hole etching process may etch two layers of second insulation layers 232, two layers of sacrificial insulation layers 230s, and two layers of first insulation layers 231. A 3rd contact hole etching process may etch four layers of second insulation layers 232, four layers of sacrificial insulation layers 230s, and four layers of first insulation layers 231.

In this case, the EPD signal may be detected by measuring the detection element included in the etching reaction gas generated when each second insulation layer 232 is etched. Whether the second insulation layer 232 is etched may be determined at the time point where the calculated EPD signal is detected. However, as described above, the level of the EPD signal may gradually decrease as the gate pattern stack structure 210 is etched.

Since a semiconductor device according to an embodiment includes the second insulation layers 232, the level of the EPD signal may not relatively decrease even when the number of the sacrificial insulation layers 230s increases. Accordingly, the etching process may be accurately stopped at a desired position, and the contact holes CT1 to CT8 having different heights may be stably and reliably formed.

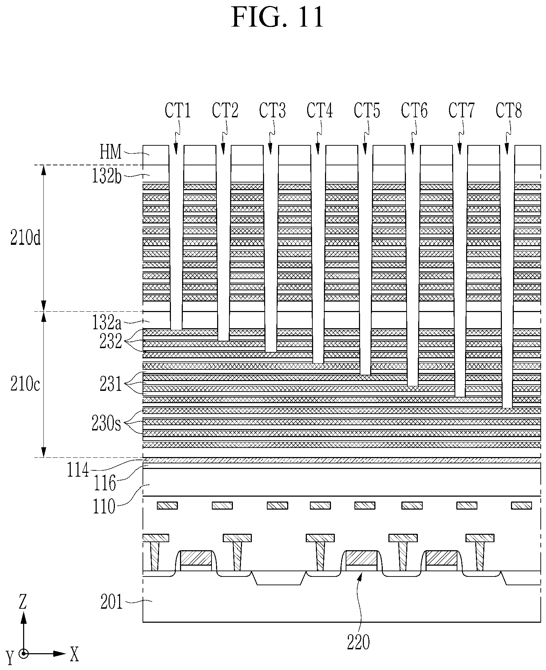

Referring to FIG. 11, portions of each of the second insulation layers 232 exposed through the first to eighth contact holes CT1 to CT8 are etched. Accordingly, the corresponding sacrificial insulation layers 230s below each of the etched second insulation layers 232 may be exposed.

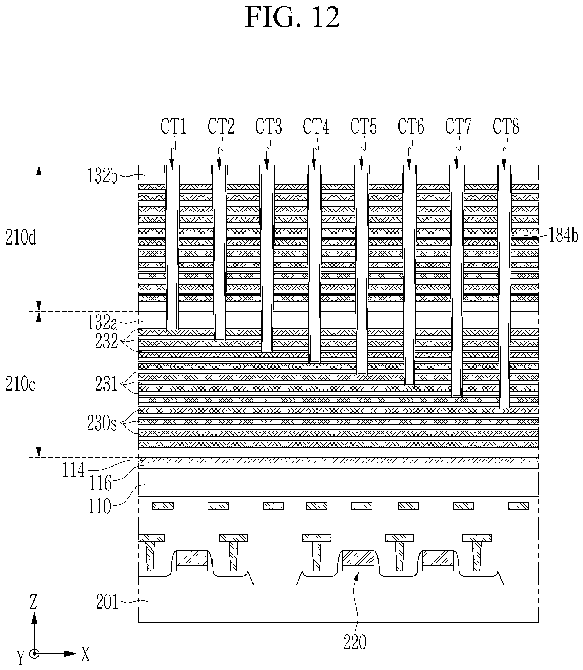

Referring to FIG. 12, the hard mask HM is removed, and gate spacers 184b are formed on sidewalls and lower surfaces of the first to eighth contact holes CT1 to CT8. The gate spacer 184b may be formed by depositing an insulation layer on sidewalls and lower surfaces of the first to eighth contact holes CT1 to CT8 and by performing anisotropic etching on the insulation layer. The gate spacers 184b may be simultaneously formed in all contact holes CT, but the embodiments are not limited thereto. The gate spacer 184b includes a material having an etch selectivity with respect to the sacrificial insulation layer 230s. The gate spacer 184b may include, e.g., a silicon oxide layer or a silicon nitride layer.

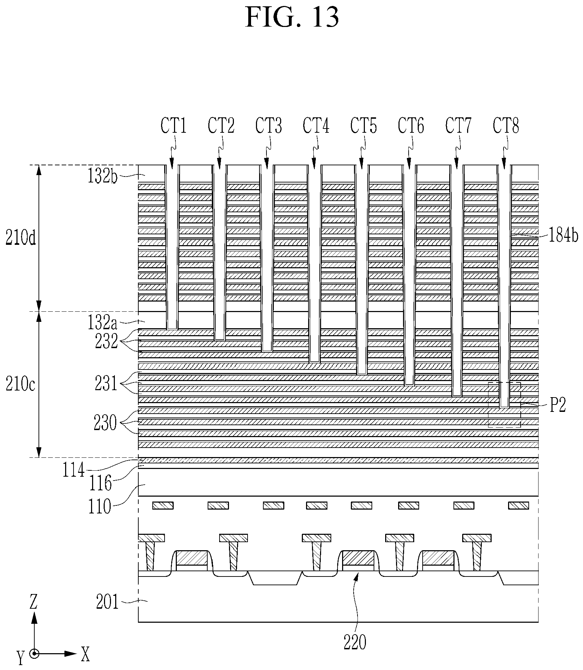

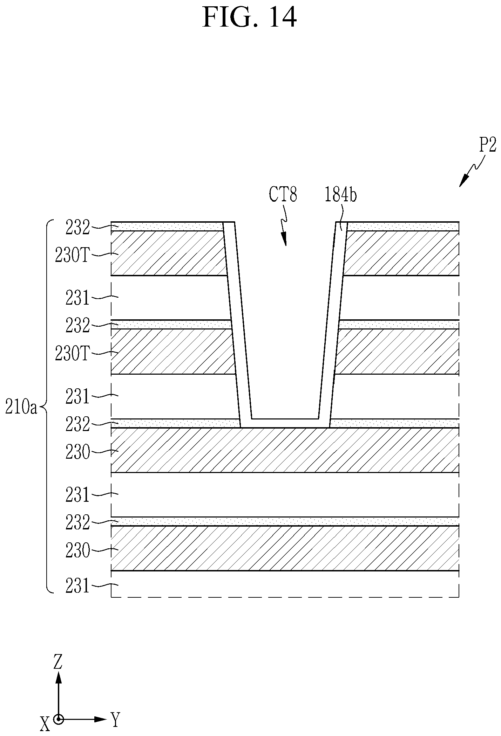

Referring to FIG. 13 and FIG. 14, the sacrificial insulation layers 230s may be removed and the gate patterns 230 may be filled in the removed space.

In more detail, an isolation trench entirely exposing the sidewall of the sacrificial insulation layers 230s, the sidewall of the first insulation layers 231, and the entire sidewall of the second insulation layers 232 is formed, and the sacrificial insulation layers 230s exposed by the isolation trench may be removed. The isolation trench may be formed corresponding to a portion where the separation structure 146 is to be formed. The sacrificial insulation layers 230s may be selectively removed using an etching solution having an etching selectivity with respect to the first insulation layers 231 and the second insulation layers 232. At this time, gate spacers 184b positioned on lower surfaces of the first to eighth contact holes CT1 to CT8 may be exposed.

Subsequently, gate patterns 230 may be formed in the removed space. The gate patterns 230 may be formed by depositing a conductive material such as tungsten (W), copper (Cu), or aluminum (Al) in a space where the sacrificial insulation layers 230s are removed using an etching process. Each of the gate patterns 230 may have a structure integrated with a corresponding gate electrode 130. Here, to have a structure integrated with the gate electrode may mean to be formed of continuous layers formed together in the same process and having the same material. That is, the gate patterns 230 may be formed together in the same process of forming the gate electrodes 130.

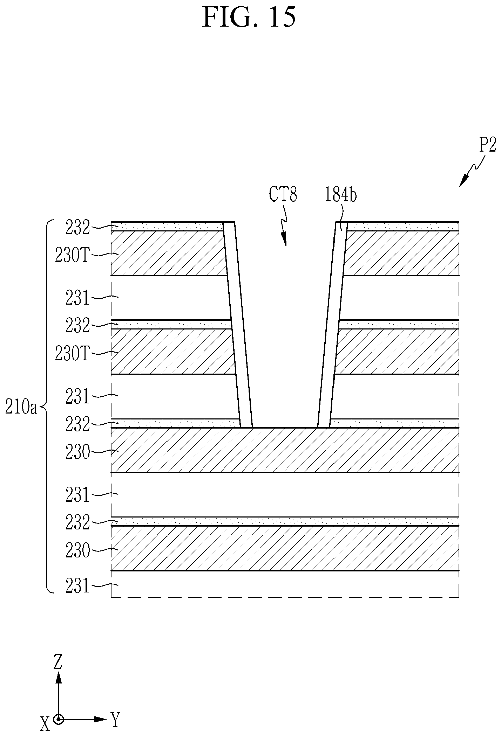

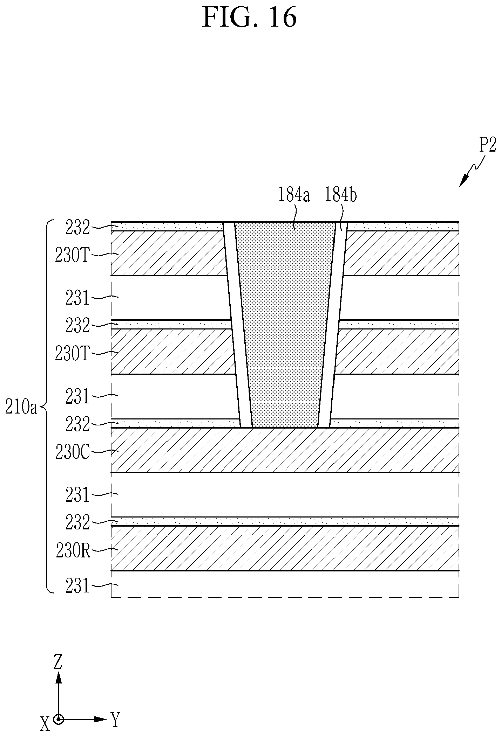

Referring to FIGS. 15 and 16, for each contact hole CT, the gate pattern 230 immediately below the contact hole CT may be exposed by removing the lower surface of the gate spacer 184b. The gate contact portions 184a respectively connected to the gate patterns 230 may be formed. At this time, the process of removing the lower surface of the gate spacer 184b may be performed using dry etching, but is not limited thereto. The gate spacer 184b may include a material having an etch selectivity with respect to the gate pattern 230. As the lower surface of the gate spacer 184b is removed, the gate pattern 230 may be exposed.

A conductive material may be deposited in the first to eighth contact holes CT1 to CT8 to form the gate contact portions 184a. Accordingly, for each contact hole CT the lower surface of the gate spacer 184b may be aligned on the same boundary as the lower surface of the gate contact portion 184a. That is, the lower surface of the gate spacer and the lower surface of the gate contact portion 184a may be positioned at substantially the same level. The lower surface of the gate contact portion 184a may be connected to (e.g., in contact with) the gate electrode 230C as a whole.

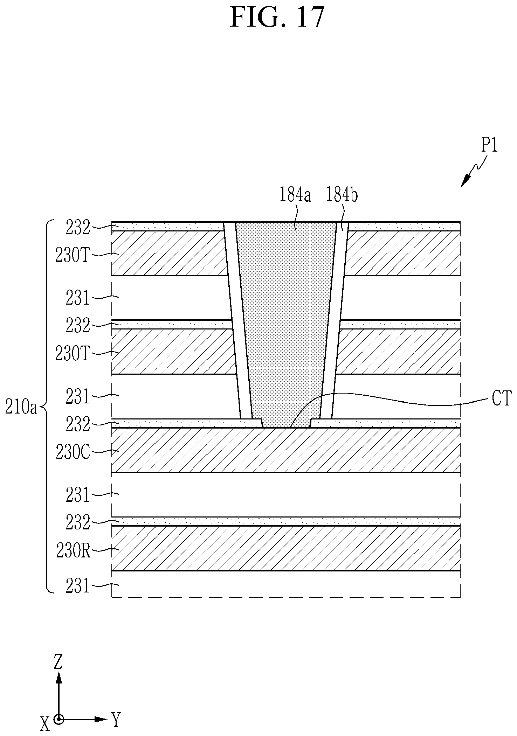

Hereinafter, semiconductor devices according to various embodiments will be described with reference to FIGS. 17 to 24. Detailed descriptions of parts identical to or substantially similar to those already described will be omitted, and only other parts will be described in detail.

FIG. 17 is an enlarged cross-sectional view corresponding to P1 of FIG. 1 illustrating a semiconductor device according to an embodiment.

Referring to FIG. 17, in an embodiment, for each contact hole CT, a second insulation layer 232 may be positioned between the gate contact portion 184a and the connection gate pattern 230C. That is, in a plan view, at least a portion of the lower surface of the gate contact portion 184a may overlap the second insulation layer 232. At least a portion of the lower surface of the gate contact portion 184a may be in contact with the second insulation layer 232, and another portion thereof may overlap (for example, in contact with) the second insulation layer 232, in a plan view.

In addition, at least a portion of the side surface of the gate contact portion 184a may be surrounded by the gate spacer 184b. The remaining portion of the side surface of the gate contact portion 184a may be surrounded by the second insulation layer 232. In this case, since the gate contact portion 184a is surrounded by the gate spacer 184b and the second insulation layer 232, it may be insulated from the adjacent gate patterns 230R.

At this time, since a portion of the lower surface of the gate contact portion 184a is in contact with the connection gate pattern 230C in the vertical direction (Z-axis direction in the drawing) perpendicular to the second substrate 110, electrical connection may be maintained.

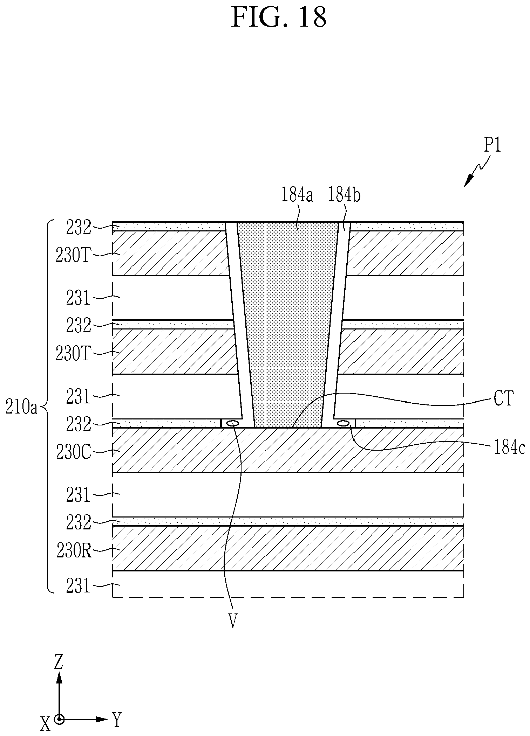

FIG. 18 is an enlarged cross-sectional view corresponding to P1 of FIG. 1, showing a semiconductor device according to an embodiment.

Referring to FIG. 18, in an embodiment, for one or more of the contact holes CT, the gate spacer 184b may further extend outward of the contact hole CT. The gate spacer 184b may include a first protrusion portion 184c extending along the upper surface of the connection gate pattern 230C. The first protrusion portion 184c may have a ring shape in a plane. In a process of etching the portion of the second insulation layer 232 exposed through the contact hole CT, the second insulation layer 232 may be excessively etched to form a recess. The gate spacer 184b may be formed in the recess to form the first protrusion portion 184c.

The first protrusion portion 184c of the gate spacer 184b may include a void V. In an implementation, the void V may extend horizontally within the first protrusion portion 184c. However, the embodiments are not limited thereto, and the void V may not be provided.

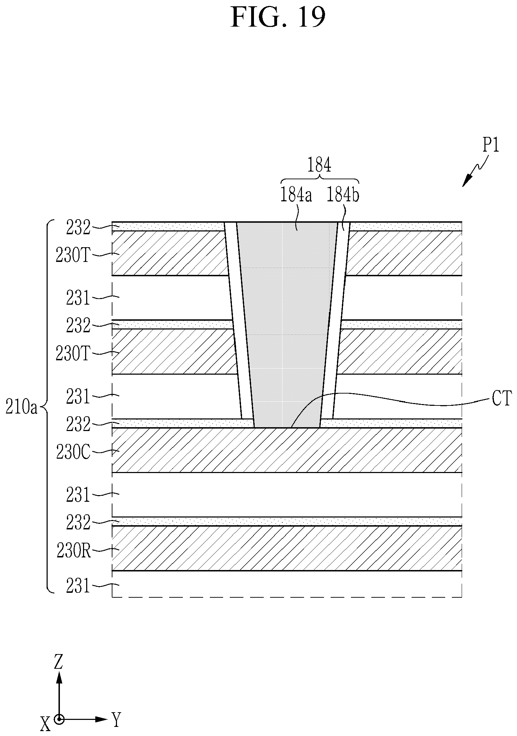

FIG. 19 is an enlarged cross-sectional view corresponding to P1 of FIG. 1, showing a semiconductor device according to an embodiment.

Referring to FIG. 19, in an embodiment, for one or more of the contact holes CT, the second insulation layer 232 may be positioned between the gate spacer 184b and the connection gate pattern 230C. That is, in a plan view, the lower surface of the gate spacer 184b may overlap the second insulation layer 232. The lower surface of the gate spacer 184b may be in contact with the second insulation layer 232.

The gate contact portion 184a may further protrude from the lower surface of the gate spacer 184b in the vertical direction (Z-axis direction in the drawing) perpendicular to the second substrate 110. Accordingly, the lower surface of the gate contact portion 184a may be in contact with the connection gate pattern 230C. However, it is not limited thereto, and the gate contact portion 184a may be buried in the connection gate pattern 230C.

In addition, at least a portion of the side surface of the gate contact portion 184a may be surrounded by the gate spacer 184b. The remaining portion of the side surface of the gate contact portion 184a may be surrounded by the second insulation layer 232. In this case, since the gate contact portion 184a is surrounded by the gate spacer 184b and the second insulation layer 232, it may be insulated from the adjacent gate patterns 230R.

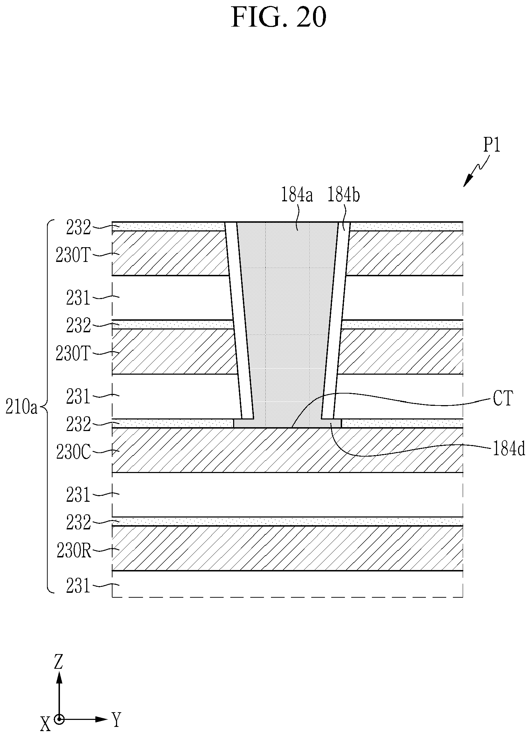

FIG. 20 is an enlarged cross-sectional view corresponding to P1 of FIG. 1, showing a semiconductor device according to an embodiment.

Referring to FIG. 20, in an embodiment, for one or more of the contact holes CT, the gate contact portion 184a may be positioned between the gate spacer 184b and the connection gate pattern 230C. That is, the gate contact portion 184a may further extend outward of the contact hole CT. The gate contact portion 184a may include a second protrusion portion 184d extending along the upper surface of the connection gate pattern 230C. The second protrusion portion 184d may have a ring shape in a plane. An upper surface of the second protrusion portion 184d may be in contact with the lower surface of the gate spacer 184b and a lower surface of the first insulation layer 231.

In this case, since the area of the gate contact portion 184a in contact with the upper surface of the connection gate pattern 230C is increased, it is possible to stably connect the connection gate pattern 230C and the gate contact portion 184a.

In addition, at least a portion of the side surface of the gate contact portion 184a may be surrounded by the gate spacer 184b. The remaining portion of the side surface of the gate contact portion 184a may be surrounded by the second insulation layer 232.

FIG. 21 is an enlarged cross-sectional view corresponding to P1 of FIG. 1, showing a semiconductor device according to an embodiment.

Referring to FIG. 21, in an embodiment, for one or more of the contact holes CT, a gate spacer 185 may be positioned between the gate contact portion 184a and the gate patterns 230, but not between the gate contact portion 184a and the second insulation layers 232, and not between the gate contact portion 184a and the first insulation layers 231. Accordingly, the side surface of the gate contact portion 184a and a side surface of the first insulation layers 231, and the side surface of the gate contact portion 184a and a side surface of the second insulation layers 232 may be in contact with each other.

After forming the contact holes CT partially penetrating the first and second stack structures 210c and 210d, the gate spacer 185 may be formed by removing a portion of the sacrificial insulation layers (230s of FIG. 6) exposed by the contact holes CT by an etchback process and then forming a gate spacer material layer in a corresponding portion.

Even in this case, at least a portion of the side surface of the gate contact portion 184a may be surrounded by the gate spacer 185. The remaining portion of the side surface of the gate contact portion 184a may be surrounded by the first insulation layers 231 and the second insulation layers 232. In this case, since the gate contact portion 184a is surrounded by the gate spacer 184b, the first insulation layers 231, and the second insulation layers 232, it may be insulated from the adjacent gate patterns 230R.

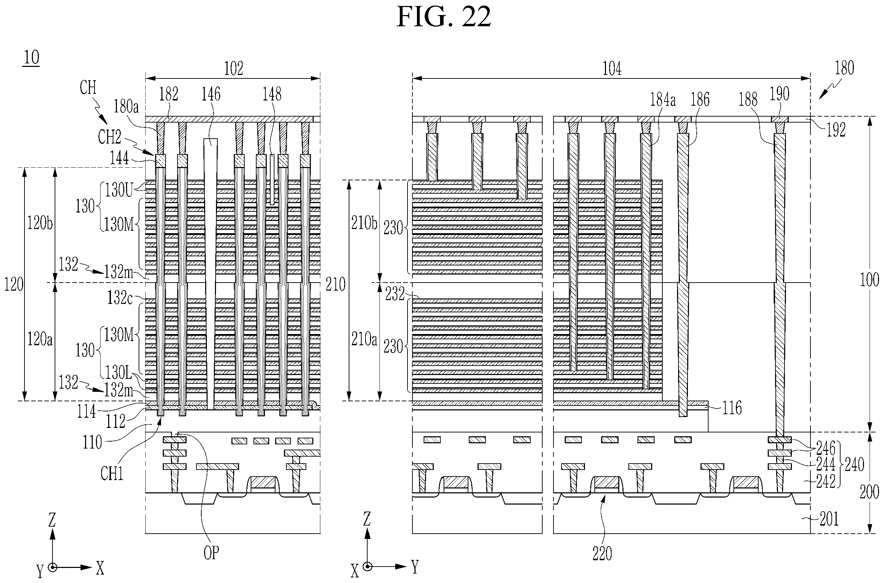

Next, a semiconductor device according to an embodiment will be described with reference to FIGS. 22 to 24.

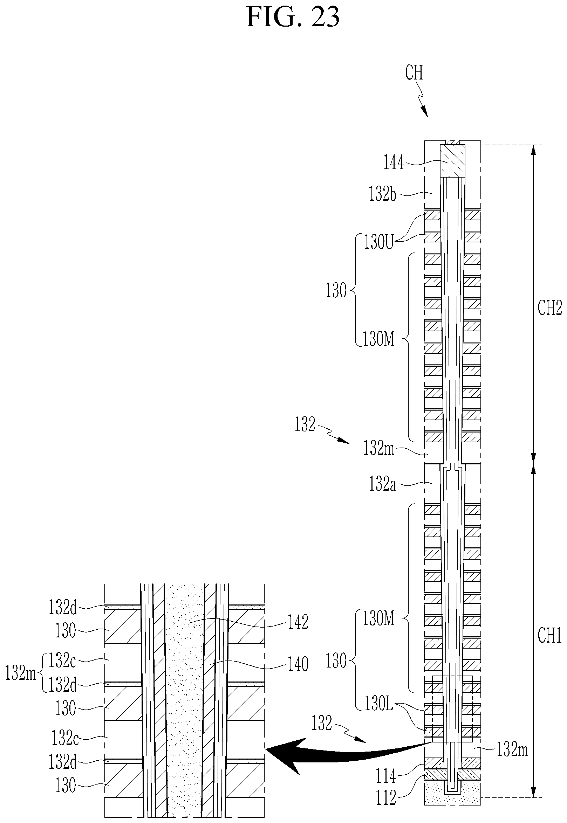

FIG. 22 is a cross-sectional view illustrating a semiconductor device according to an embodiment. FIG. 23 is a cross-sectional view illustrating an example of a channel structure included in the semiconductor device shown in FIG. 22.

Referring to FIG. 22 and FIG. 23, the interlayer insulation layers 132m of the gate stack structure 120 may each include a second interlayer insulation layer 132d and a first interlayer insulation layer 132c sequentially positioned on the gate electrode 130. In an implementation, with reference to one gate electrode 130, the first interlayer insulation layer 132c may be positioned on a lower surface of the gate electrode 130, and the second interlayer insulation layer 132d may be positioned on an upper surface of the gate electrode 130. That is, within the gate stack structure 120, the gate electrodes 130, and the second interlayer insulation layers 132d and the first interlayer insulation layers 132c may be sequentially stacked repeatedly.

In some embodiments, the first interlayer insulation layers 132c may be in contact with the first side of the first insulation layers 231. That is, each of the first insulation layers 231 may correspond to one of the first interlayer insulation layers 132c. In an implementation, the number of first insulation layers 231 may be equal to the number of first interlayer insulation layer 132c. The first insulation layers 231 may be extended from the first interlayer insulation layers 132c.

In addition, the second interlayer insulation layers 132d may be in contact with the first side of the second insulation layers 232. That is, each of the second insulation layers 232 may correspond to one of the second interlayer insulation layers 132d. In an implementation, the number of second insulation layers 232 may be equal to the number of second interlayer insulation layers 132d. The second insulation layers 232 may extend from the second interlayer insulation layers 132d.

In some embodiments, the first insulation layers 231 and the first interlayer insulation layers 132c and/or the second insulation layers 232 and the second interlayer insulation layers 132d may have an integrated structure. That is, corresponding ones of the first insulation layers 231 may be integrated with corresponding ones of the first interlayer insulation layers 132c and/or corresponding ones of the second insulation layers 232 may be integrated with corresponding ones of the second interlayer insulation layers 132d. Here, to have an integrated structure may mean to be formed of continuous layers formed together in the same process and having the same material. That is, each first insulation layer 231 may be formed together in the process of forming the corresponding first interlayer insulation layer 132c, and the first interlayer insulation layer 132c and the corresponding first insulation layer 231 may form the same layer. In addition, each second insulation layer 232 may be formed together in the process of forming the corresponding second interlayer insulation layer 132d, and the second interlayer insulation layer 132d and the second insulation layer 232 may form a same layer. In this manner, manufacturing process may be simplified.

Even if the second interlayer insulation layer 132d constituting the same layer as the second insulation layer 232 is provided in the cell array region 102, cell characteristics may not be significantly affected. In an implementation, if the second interlayer insulation layer 132d has a low permittivity, parasitic capacitance between the vertically stacked gate electrodes 130 during operation of the semiconductor device may be reduced.

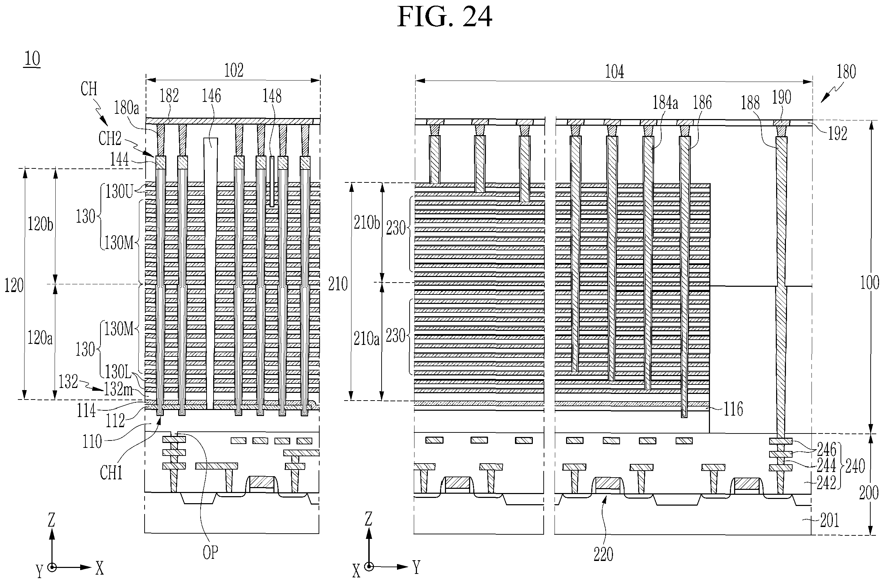

FIG. 24 is a cross-sectional view illustrating a semiconductor device according to an embodiment.

Referring to FIG. 24, the interlayer insulation layer 132m positioned in an uppermost portion of the first gate stack structure 120a may be in direct contact with the gate electrode 130 positioned in a lowermost portion of the second gate stack structure 120b. In an implementation, when the gate stack structure 120 includes a two gate stack structure, the intermediate insulation layer may not be between the first gate stack structure 120a and the second gate stack structure 120b. That is, the gate electrodes 130 (e.g. the lowermost gate electrode 130 of the second gate stack structure 120b) of the second gate stack structure 120 may be on the interlayer insulation layer 132m in the uppermost portion of the first gate stack structure 120 (e.g. the uppermost interlayer insulation layer 132m of the first gate stack structure 120).

In addition, the second insulation layer 232 in an uppermost portion of a first gate pattern stack structure 210a may be in direct contact with the gate electrode 130 in a lowermost portion of a second gate pattern stack structure 210b. In an implementation, when the gate pattern stack structure 210 includes a two gate stack structure, the intermediate insulation layer may not be between the first gate pattern stack structure 210a and the second gate pattern stack structure 210b. That is, the gate pattern 230 of the second gate pattern stack structure 210b (e.g. the lowermost gate pattern 230 of the second gate pattern stack structure 210b) may be on the insulation layers 231 and 232 in an uppermost portion of the first gate pattern stack structure 210a (the uppermost insulation layers 231 and 232 of the the first gate pattern stack structure 210a).

In the contact region 104, the source contact portion 186 penetrates the gate pattern stack structure 210 and may be electrically connected to the horizontal conductive layers 112 and 114 and/or the second substrate 110.

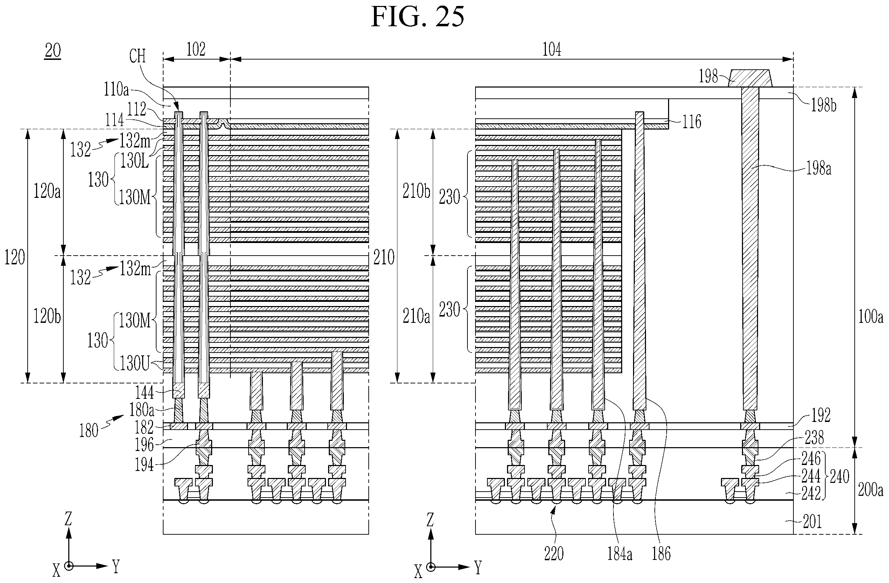

Next, a semiconductor device according to an embodiment will be described with reference to FIG. 25.

FIG. 25 is a cross-sectional view illustrating a semiconductor device according to an embodiment. Since the embodiment shown in FIG. 25 has substantially the same parts as the embodiment shown in FIGS. 1 to 3, a full description thereof will be omitted and only differences will be mainly described. In addition, the same reference numerals are used for the same components as in the previous embodiment.

Referring to FIG. 25, a semiconductor device 20 according to an embodiment may have a chip to chip (C2C) structure bonded by a wafer bonding method. That is, a lower chip including a circuit region 200a formed on the first substrate 201 is manufactured, an upper chip including a cell region 100a formed on the second substrate 110 is manufactured, and then the semiconductor device 20 may be manufactured by bonding them.

The circuit region 200a may be provided with a first bonding structure 238 on a surface of the first substrate facing the cell region 100a, the circuit element 220, and the first wire portion 240.

The cell region 100a may be provided with a second bonding structure 194 on a surface of the second substrate 110 facing the circuit region 200a, the gate stack structure 120, the channel structure CH, and the second wire portion 180.

In the gate stack structure 120, the gate electrodes 130 may include the lower gate electrode 130L, the memory cell gate electrode 130M, and the upper gate electrode 130U that are sequentially positioned on the second substrate 110 toward the circuit region 200a. That is, as shown in FIG. 25, the gate stack structure 120 is sequentially stacked downward under the second substrate 110 in the drawing, and the gate stack structure 120 shown in FIGS. 1 to 3 may have a form that is inverted upside down.

Accordingly, the channel pad 144 and the second wire portion 180 positioned on the gate stack structure 120 may be positioned adjacent to the circuit region 200a. In addition, the second bonding structure 194 electrically connected to the second wire portion 180 may be provided on a surface facing the circuit region 200a. A region other than the second bonding structure 194 may be covered by an insulation layer 196. As such, in the cell region 100a, the second wire portion 180 and the second bonding structure 194 may be positioned to face the circuit region 200a.

In an implementation, the second bonding structure 194 of the cell region 100a and the first bonding structure 238 of the circuit region 200a may be made of aluminum, copper, tungsten, or an alloy including the same. In an implementation, the first and second bonding structures 238 and 194 may include copper, and the cell region 100a and the circuit region 200a may be connected by copper-to-copper bonding (for example, bonded to in direct contact).

Although FIG. 25 illustrates that the gate stack structure 120 includes a plurality of gate structures 120a and 120b, the gate stack structure 120 may be configured as a single gate stack structure. Except as otherwise described, descriptions of the structures of the gate stack structure 120 and the channel structure CH described with reference to FIGS. 1 to 3 may be applied as they are. In FIG. 25, the electrical connection structure between the channel structure CH, the horizontal conductive layers 112 and 114, and/or the second substrate 110 is the same as is shown in FIG. 1. The embodiments are not limited thereto, and the electrical connection structure between the channel structure CH, the horizontal conductive layers 112 and 114, and/or the second substrate 110 may be variously changed as suitable.

The semiconductor device 20 according to an embodiment may include an input/output pad 198 and an input/output connection wire 198a electrically connected thereto. The input/output connection wire 198a may be electrically connected to a portion of the second bonding structure 194. The input/output pad 198 may be on, e.g., an insulation layer 198b that covers an exterior surface of the second substrate 110. Depending on the needs of an implementation, separate input/output pad electrically connected to the circuit region 200a may be provided.

In an implementation, the circuit region 200a and the cell region 100a may be portions that correspond to the first structure 1100F and the second structure 1100S of the semiconductor device 1100 included in the electronic system 1000 shown in FIG. 26, respectively. Alternatively, the circuit region 200a and the cell region 100a may be portions that correspond to the first structure 4100 and the second structure 4200 of the semiconductor chip 2200 shown in FIG. 29, respectively.

Next, an electronic system including a semiconductor device according to an embodiment will be described with reference to FIG. 26.

FIG. 26 is a drawing schematically illustrating an electronic system including a semiconductor device according to an embodiment.

As shown in FIG. 26, the electronic system 1000 according to an embodiment may include a controller 1200 electrically connected to the semiconductor device 1100. The electronic system 1000 may be an electronic device that includes a storage device or storage device including one or a plurality of semiconductor devices 1100. In an implementation, the electronic system 1000 may be a solid state drive (SSD) device, a universal serial bus (USB), a computing system, a medical device, or a communication device that includes one or a plurality of semiconductor devices 1100.

The semiconductor device 1100 may be a nonvolatile memory device, and may be, e.g., a NAND flash memory device described with reference to FIG. 1 to FIG. 25. The semiconductor device 1100 may include a first structure 1100F and a second structure 1100S on the first structure 1100F. In an embodiment, the first structure 1100F may be disposed next to the second structure 1100S. The first structure 1100F may be the peripheral circuit structure that includes a decoder circuit 1110, a page buffer 1120, and a logic circuit 1130. The second structure 1100S may be a memory cell structure that includes a bit line BL, a common source line CSL, a word line WL, first and second gate upper lines UL1 and UL2, first and second gate lower lines LL1 and LL2, and a memory cell string CSTR between the bit line BL and the common source line CSL.

In the second structure 1100S, each of the memory cell strings CSTR may include lower transistors LT1 and LT2 adjacent to the common source line CSL, upper transistors UT1 and UT2 adjacent to the bit line BL, and a plurality of memory cell transistors MCT between the lower transistors LT1 and LT2 and the upper transistors UT1 and UT2. The number of the lower transistors LT1 and LT2 and the number of the upper transistors UT1 and UT2 may be variously changed according to embodiments.

In an embodiment, the lower transistors LT1 and LT2 may include a ground select transistor, and the upper transistors UT1 and UT2 may include a string select transistor. The first and second gate lower lines LL1 and LL2 may be gate electrodes of the lower transistors LT1 and LT2, respectively. The word line WL may be a gate electrode of the memory cell transistor MCT, and the gate upper lines UL1 and UL2 may be gate electrodes of the upper transistors UT1 and UT2, respectively.

The common source line CSL, the first and second gate lower lines LL1 and LL2, the word line WL, and the first and second gate upper lines UL1 and UL2 may be electrically connected to the decoder circuit 1110 through a first connection wire 1115 extended from inside the first structure 1100F to the second structure 1100S. The bit line BL may be electrically connected to the page buffer 1120 through a second connection wire 1125 extended from inside the first structure 1100F to the second structure 1100S.

In the first structure 1100F, the decoder circuit 1110 and the page buffer 1120 may execute a control operation on at least one memory cell transistor selected from among the plurality of memory cell transistors MCT. The decoder circuit 1110 and the page buffer 1120 may be controlled by the logic circuit 1130. The semiconductor device 1100 may communicate with the controller 1200 through an input/output pad 1101 electrically connected to the logic circuit 1130. The input/output pad 1101 may be electrically connected to the logic circuit 1130 an input/output connection wire 1135 extending from inside the first structure 1100F to the second structure 11005.

The controller 1200 may include a processor 1210, a NAND controller 1220, and a host interface 1230. Depending on the embodiment, the electronic system 1000 may include the plurality of semiconductor devices 1100, and in this case, the controller 1200 may control the plurality of semiconductor devices 1100.

The processor 1210 may control the overall operation of the electronic system 1000 including the controller 1200. The processor 1210 may operate according to predetermined firmware and access the semiconductor device 1100 by controlling the NAND controller 1220. The NAND controller 1220 may include a NAND interface 1221 that processes communication with the semiconductor device 1100. Through the NAND interface 1221, a control command for controlling the semiconductor device 1100, data to be written to the memory cell transistor MCT of the semiconductor device 1100, and data to be read from the memory cell transistor MCT of the semiconductor device 1100, and the like may be transmitted. The host interface 1230 may provide a communication function between the electronic system 1000 and an external host. Upon receiving a control command from the external host through the host interface 1230, the processor 1210 may control the semiconductor device 1100 in response to the control command.

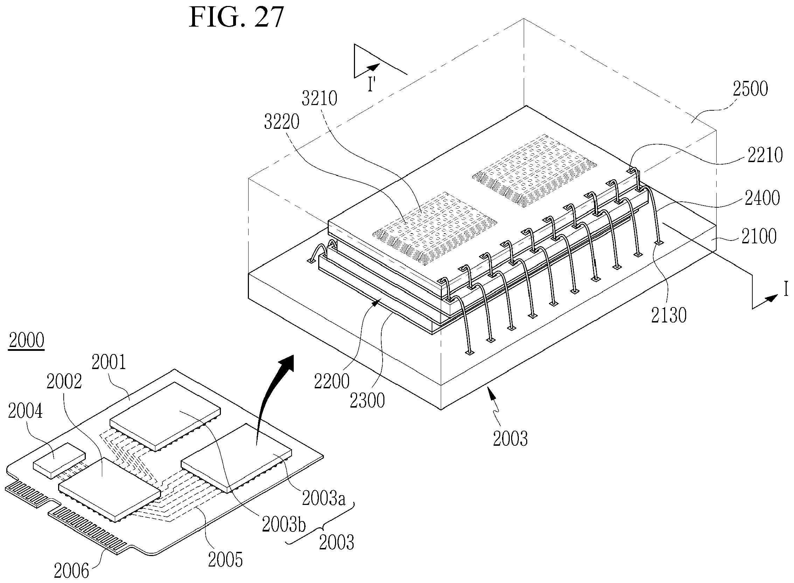

FIG. 27 is a perspective view schematically illustrating an electronic system including a semiconductor device according to an embodiment.

As shown in FIG. 27, an electronic system 2000 according to an embodiment may include a main substrate 2001, a controller 2002 mounted on the main substrate 2001, one or more a semiconductor package 2003, and a DRAM 2004. The semiconductor package 2003 and the DRAM 2004 may be connected to the controller 2002 by a wiring pattern 2005 formed on the main substrate 2001.

The main substrate 2001 may include a connector 2006 that includes a plurality of pins coupled to the external host. The number and arrangement of the plurality of pins in the connector 2006 may vary according to the communication interface between the electronic system 2000 and the external host. In an embodiment, the electronic system 2000 may communicate with the external host through one of interfaces such as a universal serial bus (USB), a peripheral component interconnect express (PCI-Express), a serial advanced technology attachment (SATA), M-Phy for a universal flash storage (UFS), and the like. In an embodiment, the electronic system 2000 may operate with power supplied from the external host through the connector 2006. The electronic system 2000 may further include a power management integrated circuit (PMIC) that distributes the power supplied from the external host to the controller 2002 and the semiconductor package 2003.

The controller 2002 may write data to the semiconductor package 2003 or read data from the semiconductor package 2003 and may improve the operating speed of the electronic system 2000.

The DRAM 2004 may be a buffer memory for mitigating a speed difference between the external host and the semiconductor package 2003, which is a data storage space. The DRAM 2004 included in the electronic system 2000 may also operate as a kind of cache memory, and may provide a space for temporarily storing data in a control operation for the semiconductor package 2003. When the electronic system 2000 includes the DRAM 2004, the controller 2002 may further include a DRAM controller for controlling the DRAM 2004 in addition to the NAND controller for controlling the semiconductor package 2003.

The semiconductor package 2003 may include first and second semiconductor packages 2003a and 2003b spaced apart from each other. The first and second semiconductor packages 2003a and 2003b may be semiconductor packages each including a plurality of semiconductor chips 2200. Each of the first and second semiconductor packages 2003a and 2003b may include a package substrate 2100, the semiconductor chip 2200 on the package substrate 2100, an adhesive layer 2300 disposed on each lower surface of the semiconductor chips 2200, a connection structure 2400 configured to electrically connect the semiconductor chip 2200 and the package substrate 2100, and a molding layer 2500 covering the semiconductor chip 2200 and the connection structure 2400 on the package substrate 2100.

The package substrate 2100 may be a printed circuit board including a package upper pad 2130. Each semiconductor chip 2200 may include an input/output pad 2210. The input/output pad 2210 may correspond to the input/output pad 1101 of FIG. 22. Each semiconductor chip 2200 may include a gate stack structure 3210 and a channel structure 3220. Each semiconductor chip 2200 may include the semiconductor devices described with reference to FIG. 1 to FIG. 25.

In an embodiment, the connection structure 2400 may be a bonding wire that electrically connects the input/output pad 2210 and the package the upper pad 2130. Therefore, in each of the first and second semiconductor packages 2003a and 2003b, the semiconductor chip 2200 may be electrically connected to each other by a bonding wire method, and may be electrically connected to the package the upper pad 2130 of the package substrate 2100. Depending on the embodiment, in each of the first and second semiconductor packages 2003a and 2003b, the semiconductor chip 2200 may be electrically connected to each other by connection structure including through-silicon vias (TSV) instead of the connection structure 2400 in the bonding wire type.

In an embodiment, the controller 2002 and the semiconductor chip 2200 may be included in one package. In an implementation, the controller 2002 and the semiconductor chip 2200 may be mounted on a separate interposer substrate different from the main substrate 2001, and the controller 2002 and the semiconductor chip 2200 may be connected to each other by wiring formed on the interposer substrate.

FIGS. 28 and 29 are cross-sectional views schematically illustrating a semiconductor package according to an embodiment. FIGS. 28 and 29 respectively describe an embodiment of the semiconductor package 2003 of FIG. 27, and conceptually show a region obtained by cutting the semiconductor package 2003 of FIG. 27 along the line I-I'.

Referring to FIG. 28, in the semiconductor package 2003, the package substrate 2100 may be a printed circuit board. The package substrate 2100 may include a package substrate body portion 2120, the package the upper pad 2130 disposed on an upper surface of the package substrate body portion 2120, a lower pad 2125 disposed on a lower surface of the package substrate body portion 2120 or exposed through a lower surface, and an internal wiring 2135 disposed within the package substrate body portion 2120 and configured to electrically connect the upper pad 2130 and the lower pad 2125. The upper pad 2130 may be electrically connected to the connection structure 2400. The lower pad 2125 may be connected to the wiring pattern 2005 of the main substrate 2001 of the electronic system 2000 through a conductive connection portion 2800 as shown in FIG. 27.

Each of the semiconductor chips 2200 may include a semiconductor substrate 3010 and a first structure 3100 and a second structure 3200 sequentially stacked on the semiconductor substrate 3010. The first structure 3100 may include a peripheral circuit region including a peripheral wire 3110. The second structure 3200 may include a common source line 3205, the gate stack structure 3210 the common source line 3205, the channel structure 3220 and a separation structure 3230 penetrating the gate stack structure 3210, a bit line 3240 electrically connected to the channel structure 3220, and a gate connection wire electrically connected to the word line (reference numeral WL in FIG. 26) of the gate stack structure 3210.

In the semiconductor chip 2200 or semiconductor device according to an embodiment, since the gate pattern stack structure 210 includes the second insulation layer 232, an etching process for forming the contact hole CT may be easily controlled. In addition, the second insulation layer 232 may have a low permittivity, and parasitic capacitance between the vertically stacked gate patterns 230 during operation of the semiconductor device may be reduced. Accordingly, reliability and productivity of the semiconductor device may be enhanced.

Each semiconductor chip 2200 may include a through-wire 3245 electrically connected to the peripheral wire 3110 of the first structure 3100 extending into the second structure 3200. The through-wire 3245 may penetrate the gate stack structure 3210, and may be further disposed outside the gate stack structure 3210. Each of the semiconductor chip 2200 may further include an input/output connection wire 3265 electrically connected to the peripheral wire 3110 of the first structure 3100 and extending into the second structure 3200 and the input/output pad 2210 electrically connected to the input/output connection wire 3265.

In an embodiment, a plurality of semiconductor chips 2200 in the semiconductor package 2003 may be electrically connected to each other by a connection structure 2400 in the form of a bonding wire. In an embodiment, the plurality of semiconductor chips 2200 or the plurality of portions constituting the same may be electrically connected by a connection structure including through silicon vias (TSVs).

Referring to FIG. 29, in a semiconductor package 2003A, each of the semiconductor chip 2200 may include a semiconductor substrate 4010, the first structure 4100 on the semiconductor substrate 4010, and the second structure 4200 disposed on the first structure 4100 and bonded to the first structure 4100 through a wafer bonding method.

The first structure 4100 may include a peripheral circuit area including a peripheral wiring 4110 and a first bonding structure 4150. The second structure 4200 may include a common source line 4205, a gate stack structure 4210 between the common source line 4205 and the first structure 4100, a channel structure 4220 and a separation structure 4230 penetrating the gate stack structure 4210, and a second bonding structure 4250 electrically connected to the word lines (reference symbol WL of FIG. 26, the same hereinbelow) of the channel structure 4220 and the gate stack structure 4210 respectively. In an implementation, the second bonding structure 4250 may be electrically connected to the channel structure 4220 and the word line WL, respectively, through a bit line 4240 electrically connected to the channel structure 4220 and the gate connection wire electrically connected to the word line WL. The first bonding structure 4150 of the first structure 4100 and the second bonding structure 4250 of the second structure 4200 may be bonded while being in contact with each other. A bonded portion of the first bonding structure 4150 and the second bonding structure 4250 may be formed of, e.g., copper (Cu).

In the semiconductor chip 2200 or semiconductor device according to an embodiment, since the gate pattern stack structure 210 includes the second insulation layer 232, an etching process for forming the contact hole CT may be easily controlled. In addition, the second insulation layer 232 may have a low permittivity, and parasitic capacitance between the vertically stacked gate patterns 230 during operation of the semiconductor device may be reduced. Accordingly, reliability and productivity of the semiconductor device may be enhanced.

Each semiconductor chip 2200 may further include an input/output connection wire 4265 under the input/output pad 2210 and the input/output pad 2210. The input/output connection wire 4265 may be electrically connected to a portion of the second bonding structure 4250.

In an embodiment, a plurality of semiconductor chips 2200 in the semiconductor package 2003A may be electrically connected to each other by a connection structure 2400 in the form of a bonding wire. As another example, the plurality of semiconductor chips 2200 or a plurality of constituting the same may be electrically connected by a connection structure including a through-silicon via.

Example embodiments have been disclosed herein, and although specific terms are employed, they are used and are to be interpreted in a generic and descriptive sense only and not for purpose of limitation. In some instances, as would be apparent to one of ordinary skill in the art as of the filing of the present application, features, characteristics, and/or elements described in connection with a particular embodiment may be used singly or in combination with features, characteristics, and/or elements described in connection with other embodiments unless otherwise specifically indicated. Accordingly, it will be understood by those of skill in the art that various changes in form and details may be made without departing from the spirit and scope of the present invention as set forth in the following claims.

## Claims

1. A semiconductor device, comprising:

   a substrate having a cell array region and a contact region;
   the cell array region including a gate stack structure having a plurality of interlayer insulation layers and a plurality of gate electrodes alternately stacked on the substrate;
   the contact region including a gate pattern stack structure having a plurality of gate patterns and a plurality of insulation layers alternately stacked on the substrate, the plurality of gate patterns extending from and integral with the plurality of gate electrodes, the plurality of insulation layers including a first insulation layer and a second insulation layer, the second insulation layer being made of a material different than the first insulation layer, the contact region further including a gate contact portion penetrating at least a portion of the gate pattern stack structure and electrically connected to the gate pattern; and
   a channel structure penetrating the gate stack structure and extending in a direction intersecting the substrate.

2. The semiconductor device as claimed in claim 1, wherein the gate contact portion:

   penetrates a through-gate pattern that is at least a portion of the plurality of gate patterns and is insulated from the through-gate pattern by a gate spacer; and
   connects to a connection gate electrode in a lower portion of the plurality of gate patterns.

3. The semiconductor device as claimed in claim 2, wherein a lower surface of the gate contact portion is aligned on a same boundary as a lower surface of the gate spacer, or protrudes further toward the substrate beyond the lower surface of the gate spacer.

4. The semiconductor device as claimed in any preceding claim, wherein a side surface of the gate pattern stack structure is aligned in a direction perpendicular to the substrate.

5. The semiconductor device as claimed in any preceding claim, wherein the second insulation layer includes at least one element or isotope not contained in the first insulation layer and an organic polymer.

6. The semiconductor device as claimed in claim 5, wherein the second insulation layer includes at least one of carbon, boron, fluorine, potassium, gold, platinum, calcium, and titanium.

7. The semiconductor device as claimed in claim 6, wherein:

   the first insulation layer includes silicon oxide; and
   the second insulation layer includes at least one of silicon carbonate, silicon carbonate nitride, and silicon carbonitride.

8. The semiconductor device as claimed in any of claims 5-7, wherein the second insulation layer includes a metal compound having a metal different from the gate pattern or a compound doped with the metal.

9. The semiconductor device as claimed in any preceding claim, wherein the second insulation layer has an etch selectivity with respect to the first insulation layer.

10. The semiconductor device as claimed in any preceding claim, wherein the second insulation layer has a lower dielectric constant than the first insulation layer or silicon oxide.

11. The semiconductor device as claimed in any preceding claim, wherein a thickness of the second insulation layer is less than a thickness of the first insulation layer.

12. The semiconductor device as claimed in claim 11, wherein the thickness of the second insulation layer is 1/100 to 1/10 of a thickness of the interlayer insulation layer.

13. The semiconductor device as claimed in any preceding claim, wherein each of the gate patterns is formed as a same layer as a corresponding gate electrode.

14. The semiconductor device as claimed in any preceding claim, wherein:

   each of the interlayer insulation layers includes a first interlayer insulation layer and a second interlayer insulation layer positioned on a corresponding gate electrode; and
   corresponding ones of the second insulation layer and the second interlayer insulation layer are formed as a same layer, and corresponding ones of the first insulation layer and the first interlayer insulation layer are formed as a same layer.

15. The semiconductor device as claimed in claim 14, wherein:

   the first interlayer insulation layer includes silicon oxide; and
   the second interlayer insulation layer includes at least one of silicon carbonate, silicon carbonate nitride, and silicon carbonitride.

# FIG. 1

EP 4 468 842 A1

# FIG. 2A

# FIG. 2B

# FIG. 3

FIG. 4

EP 4 468 842 A1

# FIG. 5

# FIG. 6

# FIG. 7

CT1  CT2  CT3  CT4  CT5  CT6  CT7  CT8

HM

132b

210d

132a

232

231

230s

210c

114
116
110

201

220

Z
Y ⊙ → X

# FIG. 8

CT1  CT2  CT3  CT4  CT5  CT6  CT7  CT8

HM

132b

210d

132a

232

231

230s

210c

114
116

110

201

Z

Y  X

220

# FIG. 9

# FIG. 10

CT1  CT2  CT3  CT4  CT5  CT6  CT7  CT8

HM

132b

210d

132a

232

210c

231

230s

114

116

110

201

220

Z

Y  X

# FIG. 11

# FIG. 12

CT1  CT2  CT3  CT4  CT5  CT6  CT7  CT8

132b

210d

184b

132a
232

210c

231

230s

114
116
110

201

Z

Y  X

220

# FIG. 13

# FIG. 14

# FIG. 15

# FIG. 16

# FIG. 17

# FIG. 18

# FIG. 19

EP 4 468 842 A1

# FIG. 20

44

# FIG. 21

# FIG. 22

EP 4 468 842 A1

# FIG. 23

FIG. 24

# FIG. 25

EP 4 468 842 A1

# FIG. 26

## FIG. 27

EP 4 468 842 A1

# FIG. 28

# FIG. 29

Europäisches
Patentamt

European
Patent Office

Office européen
des brevets

# EUROPEAN SEARCH REPORT

**Application Number**

EP 24 15 3973

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| Y | US 2016/093524 A1 (IZUMI KEISUKE [JP] ET AL) 31 March 2016 (2016-03-31) <br> * figures 1-16 * <br> ----- | 1-15 | INV. <br> H10B41/27 <br> H01L21/768 <br> H10B41/50 |
| Y | CN 111 566 814 A (SANDISK TECHNOLOGIES LLC) 21 August 2020 (2020-08-21) <br> * paragraphs [0039], [0044], [0043]; figures 1-13 * <br> ----- | 1-15 | H10B43/27 <br> H10B43/50 |

TECHNICAL FIELDS
SEARCHED      (IPC)

H10B
H01L

The present search report has been drawn up for all claims

| Place of search | Date of completion of the search | Examiner |
|---|---|---|
| Munich | 4 July 2024 | Norga, Gerd |

CATEGORY OF CITED DOCUMENTS

X : particularly relevant if taken alone
Y : particularly relevant if combined with another
     document of the same category
A : technological background
O : non-written disclosure
P : intermediate document

T : theory or principle underlying the invention
E : earlier patent document, but published on, or
     after the filing date
D : document cited in the application
L : document cited for other reasons
...................................................................................................................
& : member of the same patent family, corresponding
     document

EPO FORM 1503 03.82 (P04C01)

## ANNEX TO THE EUROPEAN SEARCH REPORT
## ON EUROPEAN PATENT APPLICATION NO.

EP 24 15 3973

This annex lists the patent family members relating to the patent documents cited in the above-mentioned European search report.
The members are as contained in the European Patent Office EDP file on
The European Patent Office is in no way liable for these particulars which are merely given for the purpose of information.

04-07-2024

| Patent document cited in search report | | Publication date | Patent family member(s) | | Publication date |
|---|---|---|---|---|---|
| US 2016093524 | A1 | 31-03-2016 | NONE | | |
| CN 111566814 | A | 21-08-2020 | CN | 111566814 A | 21-08-2020 |
| | | | EP | 3711094 A1 | 23-09-2020 |
| | | | US | 2020152655 A1 | 14-05-2020 |
| | | | WO | 2020096674 A1 | 14-05-2020 |

For more details about this annex : see Official Journal of the European Patent Office, No. 12/82